# EUROPEAN PATENT APPLICATION

(11) **EP 4 550 420 A1**
(43) Date of publication of application: **07.05.2025**
(21) Application number: 24208961.3
(22) Date of filing: 25.10.2024
(51) Int. Cl.: H01L 25/075, H10H 29/01, H10H 29/03, H10H 29/49, H01L 25/16

(54) **DISPLAY DEVICE AND METHOD OF REPAIRING THE SAME**

(30) Priority: 30.10.2023 KR 20230147225
(71) Applicant: Samsung Display Co., Ltd., Gyeonggi-do 17113 (KR)
(72) Inventor: LEE, Tae Hee, 17113 Yongin-si (KR); LEE, Hyun Wook, 17113 Yongin-si (KR); PARK, Jang Soon, 17113 Yongin-si (KR); BAE, Sung Geun, 17113 Yongin-si (KR)
(74) Representative: Walaski, Jan Filip

(57) **Abstract**

A display device includes an emission area (EMA) and a non-emission area (NEA), first to third alignment electrodes (ALE1-ALE3) sequentially arranged in a first direction (DR1), a plurality of first light-emitting elements (LD1) disposed between the first alignment electrode (ALE1) and the second alignment electrode (ALE2) and a plurality of second light-emitting elements (LD2) disposed between the second alignment electrode (ALE2) and the third alignment electrode (ALE3), a first electrode (EL1 - comprising both the, separate, electrodes PE1 and PE3) electrically connected to a first end portion of each of the first and second plurality of light-emitting elements, (at the left for LD1, at the right for LD2) and a second electrode (EL2 - comprising the electrodes PE2 and PE4, also not connected to each other!) electrically connected to a second end portion of each of the first and second plurality of light-emitting elements (at the right of each LD1, at the left of each LD2). The emission area may include a first area (A1), a second area (A2), and a third area (A3) divided in a second direction (DR2). The first electrode (EL1) may be positioned in the first area (A1) and the second area (A2) and may be electrically disconnected in the third area (A3).

See figure 6.

## Description

### CROSS-REFERENCE TO RELATED APPLICATIONS

This application claims priority from Korean Patent Application No. 10-2023-0147225 filed on October 30, 2023 in the Korean Intellectual Property Office.

### BACKGROUND

### 1. Technical Field

The disclosure relates to a display device and a method of repairing the same.

### 2. Description of the Related Art

Recently, as interest in information display is increasing, research and development on display devices is continuously being made.

### SUMMARY

The disclosure can provide a display device having improved reliability by preventing dark spot defects, and a method of repairing the same.

A display device according to an embodiment may include an emission area and a non-emission area, a first alignment electrode, a second alignment electrode, and a third alignment electrode sequentially arranged in a first direction, a plurality of first light-emitting elements disposed between the first alignment electrode and the second alignment electrode and a plurality of second light-emitting elements disposed between the second alignment electrode and the third alignment electrode, a first electrode electrically connected to a first end portion of each of the plurality of first light-emitting elements and each of the plurality of second light-emitting elements, and a second electrode electrically connected to a second end portion of each of the plurality of first light-emitting elements and each of the plurality of second light-emitting elements. The emission area may include a first area, a second area, and a third area divided in a second direction intersecting the first direction. In a plan view, the first area may be an upper area of the emission area, the second area may be a lower area of the emission area, and the third area may be a middle area of the emission area. The first electrode may be positioned (or disposed) in the first area and the second area and may be electrically disconnected in the third area.

The second electrode may be positioned in the first area, the second area, and the third area. The first electrode may not be positioned in the third area.

A combination of the first electrode and the second electrode may include a first pixel electrode, a second pixel electrode, a third pixel electrode, and a fourth pixel electrode. The first electrode may include the first pixel electrode and the third pixel electrode spaced apart from each other. The second electrode may include the second pixel electrode and the fourth pixel electrode spaced apart from each other. The first pixel electrode, the second pixel electrode, the fourth pixel electrode, and the third pixel electrode may be sequentially disposed in the first direction at least in the emission area.

The first pixel electrode may include a 1-1 pixel electrode positioned in the first area and a 1-2 pixel electrode positioned in the second area. The second pixel electrode may include a 2-1 pixel electrode positioned in the first area, a 2-2 pixel electrode positioned in the second area, and a 2-3 pixel electrode positioned in the third area. The third pixel electrode may include a 3-1 pixel electrode positioned in the first area and a 3-2 pixel electrode positioned in the second area. The fourth pixel electrode may include a 4-1 pixel electrode positioned in the first area, a 4-2 pixel electrode positioned in the second area, and a 4-3 pixel electrode positioned in the third area.

The 1-1 pixel electrode and the 1-2 pixel electrode may be spaced apart from each other. The 3-1 pixel electrode and the 3-2 pixel electrode may be spaced apart from each other.

The 2-3 pixel electrode may have a narrower width than the 2-1 pixel electrode and the 2-2 pixel electrode in the first direction. The 4-3 pixel electrode may have a narrower width than the 4-1 pixel electrode and the 4-2 pixel electrode in the first direction.

The display device may include a contact electrode which may be positioned in the non-emission area and may connect the 2-1 pixel electrode and the 3-1 pixel electrode.

The display device may further include a first sub-electrode positioned in the non-emission area and electrically connected to the first pixel electrode, and a second sub-electrode positioned in the non-emission area and electrically connected to the third pixel electrode. The first sub-electrode may include a 1-1 sub-electrode electrically connected to the 1-1 pixel electrode, a 1-2 sub-electrode electrically connected to the 1-2 pixel electrode, and a 1-3 sub-electrode electrically connecting the 1-1 sub-electrode and the 1-2 sub-electrode. The second sub-electrode may include a 2-1 sub-electrode electrically connected to the 3-1 pixel electrode, a 2-2 sub-electrode electrically connected to the 3-2 pixel electrode, and a 2-3 sub-electrode electrically connecting the 2-1 sub-electrode and the 2-2 sub-electrode.

The 1-3 sub-electrode may have a narrower width than the 1-1 sub-electrode and the 1-2 sub-electrode in the first direction. The 2-3 sub-electrode may have a narrower width than the 2-1 sub-electrode and the 2-2 sub-electrode in the first direction.

The plurality of first light-emitting elements may include a (1a)^{th} light-emitting element positioned in the first area and electrically connected to the 1-1 and 2-1 pixel electrodes, and a (1b)^{th} light-emitting element positioned in the second area and electrically connected to the 1-2 and 2-2 pixel electrodes. The plurality of second light-emitting elements may include a (2a)^{th} light-emitting element positioned in the first area and electrically connected to the 3-1 and 4-1 pixel electrodes, and a (2b)^{th} light-emitting element positioned in the second area and electrically connected to the 3-2 and 4-2 pixel electrodes.

Each of the (1a)^{th}, (1b)^{th}, (2a)^{th}, and (2b)^{th} light-emitting elements may include a first semiconductor layer positioned at the first end portion, a second semiconductor layer positioned at the second end portion, and an active layer positioned between the first semiconductor layer and the first semiconductor layer. The second semiconductor layer may be an n-type semiconductor layer, and the first semiconductor layer may be a p-type semiconductor layer.

The display device may further include a color conversion layer disposed on the plurality of first light-emitting elements and on the plurality of second light-emitting elements, and a color filter layer disposed on the color conversion layer.

A display device according to an embodiment may include a non-emission area and an emission area, the emission area may include a first area, a second area, and a third area divided in a first direction, a first alignment electrode, a second alignment electrode, and a third alignment electrode sequentially arranged in a second direction intersecting the first direction, a plurality of light-emitting elements disposed between the first alignment electrode, the second alignment electrode, and the third alignment electrode, first through fourth pixel electrodes, wherein the first pixel electrode, the second pixel electrode, the fourth pixel electrode, and the third pixel electrode may be sequentially arranged in the second direction at least in the emission area, a first sub-electrode positioned in the non-emission area and electrically connected to the first pixel electrode, and a second sub-electrode positioned in the non-emission area and electrically connected to the third pixel electrode. Each of the first, second, third, and fourth pixel electrodes may include a first portion positioned in the first area and a second portion positioned in the second area. The first sub-electrode may include a 1-1 sub-electrode electrically connected to the first portion of the first pixel electrode and a 1-2 sub-electrode electrically connected to the second portion of the first pixel electrode. The second sub-electrode may include a 2-1 sub-electrode electrically connected to the first portion of the third pixel electrode and a 2-2 sub-electrode electrically connected to the second portion of the third pixel electrode. Each of the first and third pixel electrodes may be electrically disconnected in the third area.

The second pixel electrode may be electrically disconnected in the third area. The fourth pixel electrode may be positioned in the third area and may include a third portion electrically connecting the first portion and the second portion. The first sub-electrode may include a 1-3 sub-electrode electrically connecting the 1-1 sub-electrode and the 1-2 sub-electrode. The second sub-electrode may include a 2-3 sub-electrode electrically connecting the 2-1 sub-electrode and the 2-2 sub-electrode.

The display device may further include a dummy pattern positioned between the first portion of the second pixel electrode and the second portion of the second pixel electrode in the third area and spaced apart from the first and second portions.

The fourth pixel electrode may be electrically disconnected in the third area. The second pixel electrode may be positioned in the third area and may include a third portion electrically connecting the first portion and the second portion. The first sub-electrode may include a 1-3 sub-electrode electrically connecting the 1-1 sub-electrode and the 1-2 sub-electrode. The second sub-electrode may include a 2-3 sub-electrode electrically connecting the 2-1 sub-electrode and the 2-2 sub-electrode.

Each of the second and fourth pixel electrodes may be positioned in the third area and may include a third portion electrically connecting the first portion and the second portion. The first sub-electrode may include a 1-3 sub-electrode electrically connecting the 1-1 sub-electrode and the 1-2 sub-electrode. The 2-1 sub-electrode and the 2-2 sub-electrode may be spaced apart from each other and may be electrically disconnected.

Each of the second and fourth pixel electrodes may be positioned in the third area and may include a third portion connecting the first portion and the second portion. The second sub-electrode may include a 2-3 sub-electrode electrically connecting the 2-1 sub-electrode and the 2-2 sub-electrode. The 1-1 sub-electrode and the 1-2 sub-electrode may be spaced apart from each other and may be electrically disconnected.

A method according to an embodiment may include providing a display device that may include a non-emission area and an emission area, the emission area may include a first area, a second area, and a third area divided in a first direction, a first alignment electrode, a second alignment electrode, and a third alignment electrode sequentially arranged in a second direction intersecting the first direction, a plurality of light-emitting elements disposed between the first alignment electrode, the second alignment electrode, and the third alignment electrode, the plurality of light emitting elements may include a defective light emitting element and at least one normal light emitting element, a first electrode electrically connected to a first end portion of each of the plurality of light-emitting elements, the first electrode may be disconnected in the third area, and a second electrode electrically connected to a second end portion of each of the plurality of light-emitting elements, the second electrode may be positioned in the first to third areas; and separating one of the first electrode and the second electrode electrically connected to the at least one normal light-emitting element from one of the first and second electrodes electrically connected to the defective light-emitting element.

One of the first and second electrodes electrically connected to the at least one normal light-emitting element may be positioned in the first direction from and in a same column as the one of the first and second electrodes electrically connected to the defective light-emitting element.

### BRIEF DESCRIPTION OF THE DRAWINGS

The above and other aspects, features, and advantages of certain embodiments of the disclosure will be more apparent from the following description taken in conjunction with the accompanying drawings, in which:
FIG. 1 is a schematic perspective view illustrating a light-emitting element.
FIG. 2 is a schematic cross-sectional view of the light-emitting element of FIG. 1.
FIG. 3 is a schematic plan view illustrating a display device.
FIG. 4 is a schematic cross-sectional view illustrating a display panel of FIG. 3.
FIG. 5 is a schematic circuit diagram illustrating an electrical connection relationship between components included in a pixel of FIG. 3.
FIG. 6 is a schematic plan view illustrating a display element layer of a pixel.
FIG. 7 is a schematic plan view illustrating a first bank, first and second electrodes, and light-emitting elements included in the pixel of FIG. 6.
FIGS. 8 to 10 are schematic cross-sectional views taken along lines I-I' of FIG. 6.
FIG. 11 is a schematic cross-sectional view taken along lines II-II' of FIG. 6.
FIG. 12 illustrates a pixel and is a schematic cross-sectional view corresponding to line I-I' of FIG. 6.
FIGS. 13 and 14 are schematic plan views illustrating a state of the pixel of FIG. 6 after repairing.
FIG. 15 is a schematic cross-sectional view taken along line III-III' of FIG. 13.
FIG. 16 is a schematic plan view illustrating a state of the pixel of FIG. 6 after repairing.
FIG. 17 is a schematic cross-sectional view taken along lines IV-IV' of FIG. 16.
FIG. 18 is a schematic plan view illustrating a state of the pixel of FIG. 6 after repairing.
FIG. 19 is a schematic cross-sectional view taken along line V-V' of FIG. 18.
FIG. 20 is a schematic plan view illustrating a state of the pixel of FIG. 6 after repairing.
FIG. 21 is a schematic cross-sectional view taken along line VI-VI' of FIG. 20.

### DETAILED DESCRIPTION OF THE EMBODIMENTS

In the following description, for the purposes of explanation, numerous specific details are set forth in order to provide a thorough understanding of various embodiments or implementations of the invention. As used herein "embodiments" and "implementations" are interchangeable words that are non-limiting examples of devices or methods disclosed herein. It is apparent, however, that various embodiments may be practiced without these specific details or with one or more equivalent arrangements. Here, various embodiments do not have to be exclusive nor limit the disclosure. For example, specific shapes, configurations, and characteristics of an embodiment may be used or implemented in another embodiment.

Unless otherwise specified, the illustrated embodiments are to be understood as providing features of the invention. Therefore, unless otherwise specified, the features, components, modules, layers, films, panels, regions, and/or aspects, etc. (hereinafter individually or collectively referred to as "elements"), of the various embodiments may be otherwise combined, separated, interchanged, and/or rearranged without departing from the inventive concepts.

The use of cross-hatching and/or shading in the accompanying drawings is generally provided to clarify boundaries between adjacent elements. As such, neither the presence nor the absence of cross-hatching or shading conveys or indicates any preference or requirement for particular materials, material properties, dimensions, proportions, commonalities between illustrated elements, and/or any other characteristic, attribute, property, etc., of the elements, unless specified. Further, in the accompanying drawings, the size and relative sizes of elements may be exaggerated for clarity and/or descriptive purposes. When an embodiment may be implemented differently, a specific process order may be performed differently from the described order. For example, two consecutively described processes may be performed substantially at the same time or performed in an order opposite to the described order. Also, like reference numerals and/or reference characters denote like elements.

When an element, such as a layer, is referred to as being "on," "connected to," or "coupled to" another element or layer, it may be directly on, connected to, or coupled to the other element or layer or intervening elements or layers may be present. When, however, an element or layer is referred to as being "directly on," "directly connected to," or "directly coupled to" another element or layer, there are no intervening elements or layers present. To this end, the term "connected" may refer to physical, electrical, and/or fluid connection, with or without intervening elements. Further, the X-axis, the Y-axis, and the Z-axis are not limited to three axes of a rectangular coordinate system, such as the x, y, and z axes, and may be interpreted in a broader sense. For example, the X-axis, the Y-axis, and the Z-axis may be perpendicular to one another, or may represent different directions that are not perpendicular to one another.

For the purposes of this disclosure, "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z. As used herein, the term "and/or" includes any and all combinations of one or more of the associated listed items.

Although the terms "first," "second," etc. may be used herein to describe various types of elements, these elements should not be limited by these terms. These terms are used to distinguish one element from another element. Thus, a first element discussed below could be termed a second element without departing from the teachings of the disclosure.

Spatially relative terms, such as "beneath," "below," "under," "lower," "above," "upper," "over," "higher," "side" (e.g., as in "sidewall"), and the like, may be used herein for descriptive purposes, and, thereby, to describe one elements relationship to another element(s) as illustrated in the drawings. Spatially relative terms are intended to encompass different orientations of an apparatus in use, operation, and/or manufacture in addition to the orientation depicted in the drawings. For example, if the apparatus in the drawings is turned over, elements described as "below" or "beneath" other elements or features would then be oriented "above" the other elements or features. Thus, the term "below" can encompass both an orientation of above and below. Furthermore, the apparatus may be otherwise oriented (e.g., rotated 90 degrees or at other orientations), and, as such, the spatially relative descriptors used herein interpreted accordingly.

The terminology used herein is for the purpose of describing particular embodiments and is not intended to be limiting. As used herein, the singular forms, "a," "an," and "the" are intended to include the plural forms as well, unless the context clearly indicates otherwise. Moreover, the terms "comprises," "comprising," "includes," and/or "including," when used in this specification, specify the presence of stated features, integers, steps, operations, elements, components, and/or groups thereof, but do not preclude the presence or addition of one or more other features, integers, steps, operations, elements, components, and/or groups thereof. It is also noted that, as used herein, the terms "substantially," "about," and other similar terms, are used as terms of approximation and not as terms of degree, and, as such, are utilized to account for inherent deviations in measured, calculated, and/or provided values that would be recognized by one of ordinary skill in the art.

Various embodiments are described herein with reference to sectional and/or exploded illustrations that are schematic illustrations of embodiments and/or intermediate structures. As such, variations from the shapes of the illustrations as a result, for example, of manufacturing techniques and/or tolerances, are to be expected. Thus, embodiments disclosed herein should not necessarily be construed as limited to the particular illustrated shapes of regions, but are to include deviations in shapes that result from, for instance, manufacturing. In this manner, regions illustrated in the drawings may be schematic in nature and the shapes of these regions may not reflect actual shapes of regions of a device and, as such, are not necessarily intended to be limiting.

Unless otherwise defined or implied herein, all terms (including technical and scientific terms) used herein have the same meaning as commonly understood by those skilled in the art to which this disclosure pertains. It will be further understood that terms, such as those defined in commonly used dictionaries, should be interpreted as having a meaning that is consistent with their meaning in the context of the relevant art and the disclosure, and should not be interpreted in an ideal or excessively formal sense unless clearly so defined herein.

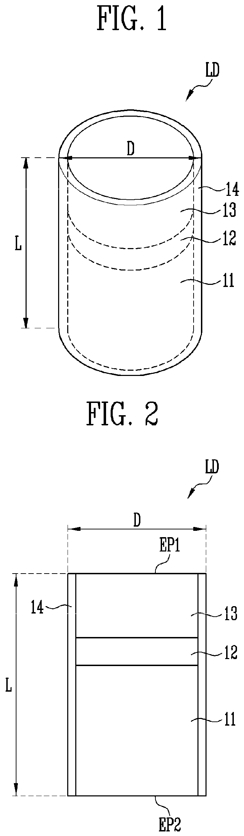

FIG. 1 is a schematic perspective view illustrating a light-emitting element LD. FIG. 2 is a schematic cross-sectional view of the light-emitting element LD of FIG. 1.

Referring to FIGS. 1 and 2, the light-emitting element LD may include a first semiconductor layer 11, a second semiconductor layer 13, and an active layer 12 disposed between the first semiconductor layer 11 and the second semiconductor layer 13. For example, the light-emitting element LD may be implemented as a light-emitting stack (or a light-emitting stack pattern) in which the first semiconductor layer 11, the active layer 12, and the second semiconductor layer 13 may be sequentially stacked on each other. However, the type and/or shape of the light-emitting element LD is not limited to that shown in FIG. 1.

The light-emitting element LD may be provided in a shape extending in a direction. In the case that an extending direction of the light-emitting element LD is a longitudinal direction, the light-emitting element LD may include a first end portion EP1 and a second end portion EP2 which may be opposite to each other in the longitudinal direction. The second semiconductor layer 13 may be positioned at the first end portion EP1 of the light-emitting element LD, and the first semiconductor layer 11 may be positioned at the second end portion EP2 of the light-emitting element LD. However, the disclosure is not limited thereto.

The light-emitting element LD may be provided in various shapes. For example, as shown in FIG. 1, the light-emitting element LD may have a rod shape, a bar shape, or a pillar shape that may be long in the longitudinal direction (for example, has an aspect ratio greater than 1). The light-emitting element LD may include a light-emitting diode (LED) that may be manufactured to have a subminiature size, that is, have a diameter D and/or length L in a range of a nanoscale (or nanometer) to a microscale (or micrometer).

In the case that the light-emitting element LD is long (extends) in the longitudinal direction, the diameter D of the light-emitting element LD may be in a range of about 0.5 µm to about 6 um, and the length L thereof may be in a range of about 1 µm to about 10 µm. However, the diameter D and length L of the light-emitting element LD are not limited thereto, and the size of the light-emitting element LD may be changed to satisfy the requirements (or design conditions) of a lighting device or a self-luminous display device to which the light-emitting element LD may be applied.

For example, the first semiconductor layer 11 may include at least one n-type semiconductor layer. For example, the first semiconductor layer 11 may include any one semiconductor material of InAlGaN, GaN, AlGaN, InGaN, AlN, and InN and may be an n-type semiconductor layer doped with a first conductive dopant (or n-type dopant) such as Si, Ge, or Sn. However, a material constituting the first semiconductor layer 11 are not limited thereto, and the first semiconductor layer 11 may be made of various other materials.

The active layer 12 (or an emission layer) may be disposed on the first semiconductor layer 11 and may be formed in a single or multi-quantum well structure. For example, in the case that the active layer 12 is formed in a multi-quantum well structure, the active layer 12 may be formed by periodically and repeatedly stacking a barrier layer, a strain reinforcing layer, and a well layer as a part. However, the structure of the active layer 12 is not limited to the above-described example.

The active layer 12 may emit light with a wavelength of 400 nm to 900 nm, and may have a double hetero structure. A clad layer doped with a conductive dopant may be formed on and/or below the active layer 12 in the longitudinal direction of the light-emitting element LD. For example, the clad layer may be formed as an AlGaN layer or an InAlGaN layer. A material such as AlGaN or InAlGaN may be used to form the active layer 12, and various other materials may constitute the active layer 12.

In the case that an electric field of a certain voltage or more is applied to both end portions of the light-emitting element LD, while electrons and holes form pair in the active layer 12, the light-emitting element LD emits light. By controlling the light-emitting of the light-emitting element LD using such a principle, the light-emitting element LD may be used as a light source (or light-emitting source) for various light-emitting elements including pixels of a display device.

The second semiconductor layer 13 may be disposed on the active layer 12 and may include a semiconductor layer of a type different from that of the first semiconductor layer 11. For example, the second semiconductor layer 13 may include at least one p-type semiconductor layer. For example, the second semiconductor layer 13 may include at least one semiconductor material selected from InAlGaN, GaN, AlGaN, InGaN, AlN, and InN and may include a p-type semiconductor layer doped with a second conductive dopant (or a p-type dopant) such as Mg, Zn, Ca, Sr, or Ba. However, a material constituting the second semiconductor layer 13 is not limited thereto, and the second semiconductor layer 13 may be made of various other materials.

The first semiconductor layer 11 and the second semiconductor layer 13 may have different thicknesses in the longitudinal direction of the light-emitting element LD. For example, the first semiconductor layer 11 may have a relatively thicker thickness than the second semiconductor layer 13 in the longitudinal direction of the light-emitting element LD, but the disclosure is not limited thereto.

In FIGS. 1 and 2, the first semiconductor layer 11 and the second semiconductor layer 13 are each shown as including one layer, but the disclosure is not limited thereto. According to the material of the active layer 12, each of the first semiconductor layer 11 and the second semiconductor layer 13 may further include one or more layers, for example, a clad layer and/or a tensile strain barrier reducing (TSBR) layer.

In addition to the above-described first semiconductor layer 11, active layer 12, and second semiconductor layer 13, the light-emitting element LD may further include a contact electrode (hereinafter referred to as "first contact electrode") disposed on the second semiconductor layer 13. Another contact electrode (hereinafter referred to as "second contact electrode") disposed at one end portion of the first semiconductor layer 11 may be further included.

Each of the first and second contact electrodes may be an ohmic contact electrodes, but are not limited thereto. The first and second contact electrodes may be Schottky contact electrodes.

Materials included in the first and second contact electrodes may be the same or different. The first and second contact electrodes may be substantially transparent or semi-transparent.

The light-emitting element LD may further include an insulating film 14. However, the insulating film 14 may be omitted and may be provided to cover only some of the first semiconductor layer 11, the active layer 12, and the second semiconductor layer 13.

The insulating film 14 may prevent an electrical short circuit that may occur in the case that the active layer 12 comes into contact with a conductive material other than the first and second semiconductor layers 11 and 13. The insulating film 14 may minimize surface defects of the light-emitting element LD to improve the lifespan and luminous efficiency of the light-emitting element LD. Furthermore, in the case that multiple light-emitting elements LD are closely arranged, the insulating film 14 may prevent undesired short circuits that may occur between the light-emitting elements LD. As long as the active layer 12 may prevent a short circuit with an external conductive material, there is no limitation on whether the insulating film 14 is provided.

The insulating film 14 may be provided in a form that entirely surrounds an outer peripheral surface of a light-emitting stack including the first semiconductor layer 11, the active layer 12, and the second semiconductor layer 13, but the disclosure is not limited thereto.

The insulating film 14 may include a transparent insulating material. Various materials having insulating properties may be used as materials of the insulating film 14. The insulating film 14 may be provided in the form of a single layer or in the form of multiple layers including a double layer.

The light-emitting element LD may be implemented as a light-emitting pattern of a core-shell structure.

The above-described light-emitting element LD) may be used as a light-emitting source (or light source) for various display devices. The light-emitting element (LD) can be manufactured through a surface treatment process.

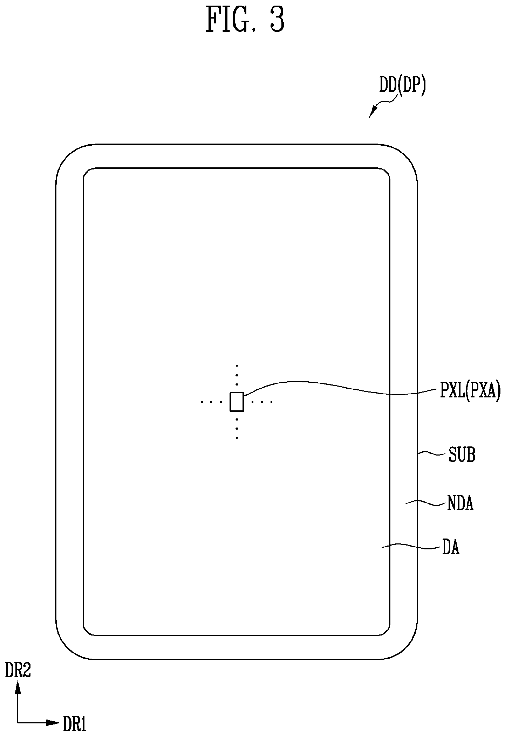

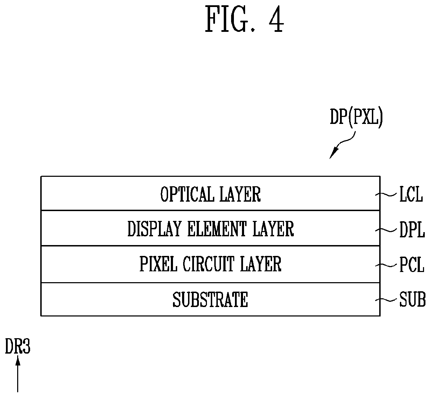

FIG. 3 is a schematic plan view illustrating a display device DD. FIG. 4 is a schematic cross-sectional view illustrating a display panel DP of FIG. 3.

In FIGS. 3 and 4, for convenience, the structure of the display panel DP provided in the display device DD may be briefly shown centered on a display area DA in which an image may be displayed.

Referring to FIGS. 1 to 4, the display device DD may be classified into a passive matrix type display device and an active matrix type display device according to a method of driving a light-emitting element LD. For example, in the case that the display device DD is implemented as an active matrix type, each of pixels PXL may include a driving transistor that controls an amount of current supplied to the light-emitting element LD and a switching transistor that transmits a data signal to the driving transistor.

The display panel DP (or the display device DD) may be provided in various shapes. For example, the display panel DP may be provided in a rectangular plate shape having two pairs of sides parallel to each other. In the case that the display panel DP is provided in the rectangular plate shape, a pair of sides may be longer than another pair of sides. In FIG. 3, an extending direction of a short side may be a first direction DR1, and an extending direction of a long side may be a second direction DR2.

At least a portion of the display panel DP may have flexibility and may be folded at a portion having flexibility, but the disclosure is not limited thereto.

The display panel DP may display images. The display panel DP may be a self-emitting display panel or a non-light-emitting display panel.

The display panel DP may include a substrate SUB and the pixels PXL provided on the substrate SUB.

The substrate SUB may include a transparent insulating material to transmit light, but the disclosure is not limited thereto. The substrate SUB may be a rigid substrate or a flexible substrate.

The rigid substrate may be, for example, one of a glass substrate, a quartz substrate, a glass ceramic substrate, a crystalline glass substrate, or a combination thereof.

The flexible substrate may be one of a film substrate containing a polymer organic material and a plastic substrate. For example, the flexible substrate include at least one of polystyrene, polyvinyl alcohol, polymethyl methacrylate, polyethersulfone, polyacrylate, polyetherimide, polyethylene naphthalate, polyethylene terephthalate, polyphenylene sulfide, polyarylate, polyimide, polycarbonate, triacetate cellulose, and cellulose acetate propionate.

An area of the substrate SUB may be provided as a display area DA in which the pixels PXL are disposed, and the remaining area of the substrate SUB may be provided as a non-display area NDA. For example, the substrate SUB may include the display area DA including pixel areas PXA in which each pixel PXL may be disposed, and the non-display area NDA disposed around the display area DA (or adjacent to the display area DA).

The non-display area NDA may be positioned adjacent to the display area DA. The non-display area NDA may be provided on at least a side of the display area DA. For example, the non-display area NDA may surround a perimeter (or an edge) of the display area DA. The non-display area NDA may be provided with a line part electrically connected to each pixel PXL and a driver electrically connected to the line part to drive the pixel PXL.

Multiple pixels PXL may be provided and arranged in a matrix form along pixel rows extending in a first direction DR1 and pixel columns extending in a second direction DR2 intersecting the first direction DR1. The arrangement form of the pixels PXL may not be particularly limited, and the pixels PXL may be arranged in various forms. In the case that the pixels PXL are provided, the pixels PXL may be provided to have different areas (or sizes). For example, in the case of the pixels PXL emitting light having different colors, according to colors, the pixels PXL may have different areas (or sizes) or may be provided in different shapes.

The driver may control the driving of each pixel PXL by providing a certain signal and a certain voltage to each pixel PXL through the line part.

The display panel DP (or each of the pixels PXL) may include a pixel circuit layer PCL, a display element layer DPL, and an optical layer LCL which are positioned on the substrate SUB.

The pixel circuit layer PCL may be provided on the substrate SUB and may include a transistor and signal lines electrically connected to the transistor. For example, the transistor may have a form in which an active pattern (or a semiconductor pattern), a gate electrode, a source electrode, and a drain electrode sequentially stacked on each other with an insulating layer disposed therebetween. The semiconductor pattern may include amorphous silicon, poly silicon, low temperature poly silicon, an organic semiconductor, and/or an oxide semiconductor. The gate electrode, the source electrode, and the drain electrode may include one of aluminum (Al), copper (Cu), titanium (Ti), molybdenum (Mo), or a combination thereof but the disclosure is not limited thereto. The pixel circuit layer PCL may include one or more insulating layers.

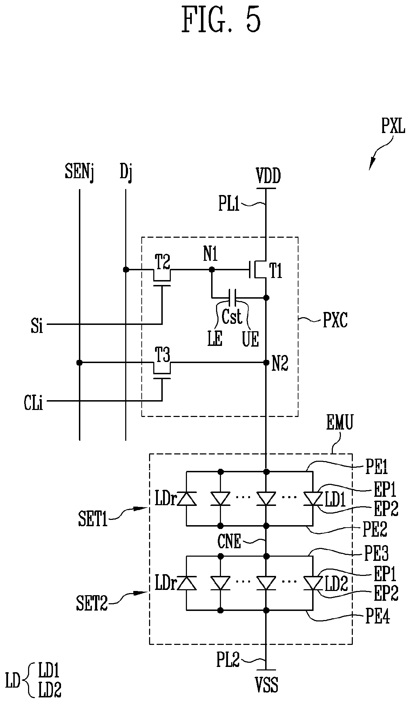

The display element layer DPL may be disposed on the pixel circuit layer PCL. An emission component (see "EMU" in FIG. 5) including the light-emitting element LD that emits light may be positioned in the display element layer DPL. Electrodes electrically connected to the light-emitting element LD may be disposed in the emission component EMU. The configuration of each pixel PXL will be described in detail below.

Each pixel PXL may include one or more light-emitting elements LD driven by a corresponding scan signal and data signal. The light-emitting element LD has a small size in a range from a nanoscale (or nanometer) to a microscale (or micrometer) and may be electrically connected adjacent light-emitting elements in parallel, but the disclosure is not limited thereto. The light-emitting element LD may constitute a light source for each pixel PXL.

The optical layer LCL may be disposed on the display element layer DPL. The optical layer LCL may convert light emitted from the light-emitting element LD into light having excellent color reproducibility to emit the light, thereby improving the emission efficiency of each pixel PXL. The optical layer LCL may include a color conversion layer and a color filter, but the disclosure is not limited thereto.

FIG. 5 is a schematic circuit diagram illustrating an electrical connection relationship between components included in the pixel PXL of FIG. 3.

For example, FIG. 5 illustrates the electrical connection relationship between components included in a pixel PXL that may be applied to an active matrix display device. However, the connection relationship between the components of each pixel PXL is not limited thereto.

Referring to FIGS. 1 to 5, the pixel PXL may include the emission component EMU that generates light with luminance corresponding to a data signal. The pixel PXL may include a pixel circuit PXC for driving the emission component EMU.

An emission component EMU may include, for example, a first pixel electrode PE1 electrically connected to a first driving power source VDD through the pixel circuit PXC and a first power line PL1, a fourth pixel electrode PE4 electrically connected to a second driving power source VSS through a second power line PL2, and multiple light-emitting elements LD electrically connected between the first pixel electrode PE1 and the fourth pixel electrode PE4. The first driving power source VDD and the second driving power source VSS may have different potentials such that the light-emitting elements LD may emit light. For example, the first driving power source VDD may be set as a high-potential power source, and the second driving power source VSS may be set as a low-potential power source.

The emission component EMU may include one or more stages electrically connected in series. Each stage may include a pair of electrodes (for example, first and second electrodes) and one or more light-emitting elements LD electrically connected in a forward direction between the pair of electrodes. The number of stages constituting the emission component EMU and the number of light-emitting elements LD constituting each stage are not limited. For example, the numbers of light-emitting elements LD constituting respective stages may be the same or different, and the number of light-emitting elements LD is not particularly limited.

For example, the emission component EMU may include a first stage SET1 including one or more first light-emitting elements LD1 and a second stage SET2 including one or more light-emitting elements LD2.

The first stage SET1 may include a first pixel electrode PE1, a second pixel electrode PE2, and one or more first light-emitting elements LD1 electrically connected between the first pixel electrode PE1 and the second pixel electrode PE2. Each first light-emitting element LD1 may be electrically connected in a forward direction between the first pixel electrode PE1 and the second pixel electrode PE2. For example, a first end portion EP1 of the first light-emitting element LD1 may be electrically connected to the first pixel electrode PE1, and the second end portion EP2 of the first light-emitting element LD1 may be electrically connected to the second pixel electrode PE2.

The second stage SET2 may include a third pixel electrode PE3, a fourth pixel electrode PE4, and one or more second light-emitting elements LD2 electrically connected between the third pixel electrode PE3 and the fourth pixel electrode PE4. Each second light-emitting element LD2 may be electrically connected in a forward direction between the third pixel electrode PE3 and the fourth pixel electrode PE4. For example, a first end portion EP1 of the second light-emitting element LD2 may be electrically connected to the third pixel electrode PE3, and the second end portion EP2 of the second light-emitting element LD2 may be electrically connected to the fourth pixel electrode PE4.

The first stage SET1 and the second stage SET2 may be electrically connected in series through a contact electrode CNE.

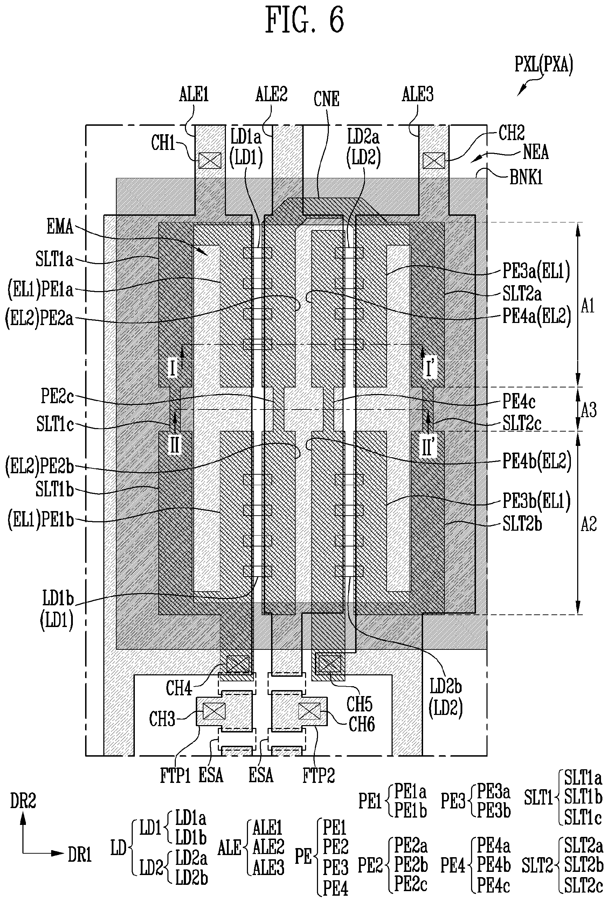

The first pixel electrode PE1 and the third pixel electrode PE3, which may be electrically connected to the first end portion of the light-emitting element LD in each stage, may be first electrodes (see "EL1" in FIG. 6) of the corresponding stage. The second pixel electrode PE2 and the fourth pixel electrode PE4, which may be electrically connected to the second end portion of the light-emitting element LD in each stage, may be second electrodes (see "EL2" in FIG. 6) of the corresponding stage.

A first electrode of the emission component EMU, for example, the first pixel electrode PE1, may be an anode of the emission component EMU. The last electrode of the emission component EMU, for example, the fourth pixel electrode PE4, may be a cathode.

In the case that the light-emitting elements LD are electrically connected in a series/parallel structure, power efficiency may be improved as compared with the case that the same number of light-emitting elements LD are electrically connected only in parallel. In the pixel PXL in which the light-emitting elements LD may be electrically connected in a series/parallel structure, certain luminance may be expressed through some light-emitting elements LD in a stage, thereby reducing the possibility of dark spot defects of the pixel PXL. However, the disclosure is not limited thereto, and the emission component EMU may be formed by connecting the light-emitting elements LD only in series or may be formed by connecting the light-emitting elements LD only in parallel.

Each of the light-emitting elements LD may include the first end portion (for example, a p-type end portion) electrically connected to a first driving power source VDD through at least an electrode (for example the first pixel electrode PE1), the pixel circuit PXC, and/or a first power line PL1 and the second end portion EP2 (for example, an n-type end portion) electrically connected to a second driving power source VSS through at least an electrode (for example, the fourth pixel electrode PE4) and a second power line PL2. For example, the light-emitting elements LD may be electrically connected in a forward direction between the first driving power source VDD and the second driving power source VSS. The light-emitting elements LD electrically connected in the forward direction may constitute effective light sources of the emission component EMU.

The emission component EMU may further include at least one reverse light-emitting element LDr in addition to the light-emitting elements LD constituting the effective light sources.

The light-emitting elements LD of the emission component EMU may emit light with luminance corresponding to a driving current supplied through the corresponding pixel circuit PXC. For example, during each frame period, the pixel circuit PXC may supply a driving current corresponding to a gray level value of corresponding frame data to the emission component EMU. A driving current supplied to the emission component EMU may be divided to flow to each light-emitting element LD. Accordingly, while each light-emitting element LD emits light with luminance corresponding to the current flowing thereto, the emission component EMU may emit light with luminance corresponding to the driving current.

The pixel circuit PXC may be electrically connected to a scan line Si and a data line Dj of the corresponding pixel PXL. For example, in the case that the pixel PXL is disposed in an i^{th} row and a j^{th} column of a display area DA, the pixel circuit PXC of the pixel PXL may be electrically connected to an i^{th} scan line Si and a j^{th} data line Dj of the display area DA. The pixel circuit PXC may be electrically connected to an i^{th} control line CLi and a j^{th} sensing line SENj of the display area DA.

The above-described pixel circuit PXC may include first to third transistors T1, T2, and T3 and a storage capacitor Cst.

The first transistor T1 may be a driving transistor for controlling a driving current applied to the emission component EMU and may be electrically connected between the first driving power source VDD and the emission component EMU. Specifically, a first terminal of the first transistor T1 may be electrically connected to the first driving power source VDD through the first power line PL1, and a second terminal of the first transistor T1 may be electrically connected to a second node N2. A gate electrode of the first transistor T1 may be electrically connected to a first node N1. The first terminal of the first transistor T1 may be a drain electrode, and the second terminal of the first transistor T1 may be a source electrode.

The second transistor T2 may be a switching transistor that selects the pixel PXL in response to a scan signal and activates the pixel PXL and may be electrically connected between the j^{th} data line Dj and the first node N1. A first terminal of the second transistor T2 may be electrically connected to the j^{th} data line Dj, and a second terminal of the second transistor T2 may be electrically connected to the first node N1 (or the gate electrode of the first transistor T1). A gate electrode of the second transistor T2 may be electrically connected to the i^{th} scan line Si. The first terminal and the second terminal of the second transistor T2 may be different terminals. For example, in the case that the first terminal is a drain electrode, the second terminal may be a source electrode.

In the case that a scan signal of a gate-on voltage (for example, a high level voltage) is supplied from the i^{th} scan line Si, the second transistor T2 may be turned on to electrically connect the j^{th} data line Dj and the first node N1. The first node N1 may be a point at which the second terminal of the second transistor T2 and the gate electrode of the first transistor T1 may be electrically connected. The second transistor T2 may transmit a data signal to the gate electrode of the first transistor T1.

The third transistor T3 may electrically connect the first transistor T1 to the j^{th} sensing line SENj to obtain a sensing signal through the j^{th} sensing line SENj) and may detect the characteristics of the pixel PXL such as a threshold voltage of the first transistor T1 using the sensing signal. Information about the characteristics of the pixel PXL may be used to convert image data such that characteristic differences between the pixels PXL may be compensated for. A second terminal of the third transistor T3 may be electrically connected to the second terminal of the first transistor T1, and a first terminal of the third transistor T3 may be electrically connected to the j^{th} sensing line SENj. A gate electrode of the third transistor T3 may be electrically connected to the i^{th} control line CLi. The first terminal of the third transistor T3 may be a drain electrode, and the second terminal of the third transistor T3 may be a source electrode.

The first terminal of the third transistor T3 may be electrically connected to an initialization power source. The third transistor T3 may be an initialization transistor capable of initializing the second node N2. In the case that a sensing control signal is supplied from the i^{th} control line CLi, the third transistor T3 and may be turned on to increase a voltage of the initialization power supply to the second node N2.

A storage capacitor Cst may include a lower electrode LE (or a first storage electrode) and an upper electrode UE (or a second storage electrode). The lower electrode LE may be electrically connected to the first node N1, and the upper electrode UE may be electrically connected to the second node N2. The storage capacitor Cst may be charged with a gate voltage corresponding to a data signal supplied to the first node N1 during a frame period. Accordingly, the storage capacitor Cst may store a voltage corresponding to a difference between a voltage of the gate electrode of the first transistor T1 and a voltage of the second node N2.

FIG. 5 illustrates an example in which the first to third transistors T1, T2, and T3 may be all n-type transistors, but the disclosure is not limited thereto. For example, at least one of the first to third transistors T1, T2, and T3 described above may be changed to a p-type transistor. The pixel circuit PXC may be electrically connected between the first driving power source VDD and the emission component EMU.

The structure of the pixel circuit PXC may be changed and implemented in various ways.

In the following, for convenience of description, a horizontal direction in a plan view may be a first direction DR1, a vertical direction in a plan view may be a second direction DR2, and a vertical direction in a cross section may be a third direction DR3.

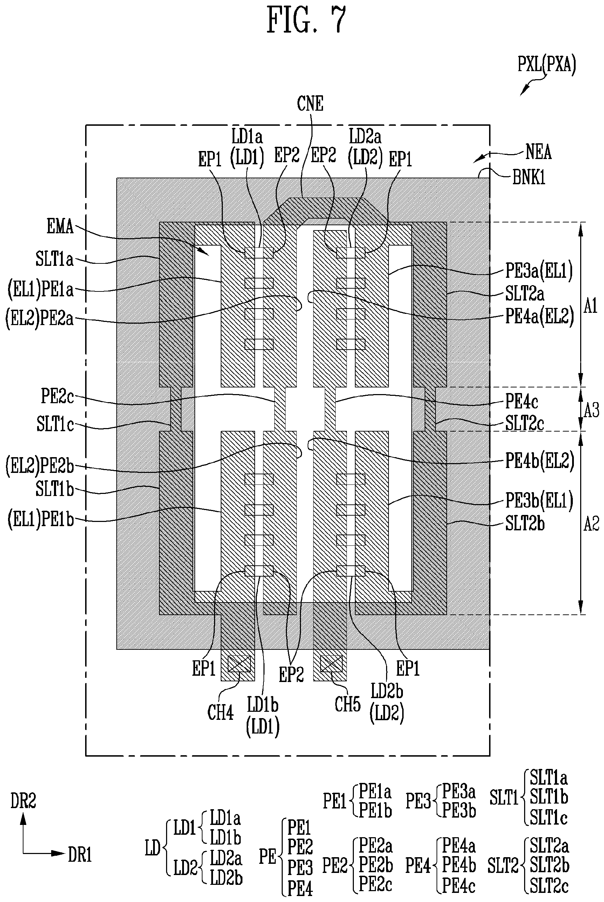

FIG. 6 is a schematic plan view illustrating a display element layer of a pixel PXL. FIG. 7 is a schematic plan view illustrating a first bank BNK1, pixel electrodes PE, and light-emitting elements LD included in the pixel PXL of FIG. 6.

In FIGS. 6 and 7, for convenience, illustration of a pixel circuit including a transistor electrically connected to the light-emitting elements LD may be omitted.

In FIGS. 6 and 7, not only components included in the pixel PXL but also an area in which the components may be positioned may be referred to as the pixel PXL.

Referring to FIGS. 1 to 7, the pixel PXL may be positioned in a pixel area PXA provided in a substrate SUB. The pixel area PXA may include an emission area EMA and a non-emission area NEA.

The pixel PXL may include the first bank BNK1 positioned in the non-emission area NEA and the light-emitting elements LD positioned in the emission area EMA.

The first bank BNK1 may be a structure that defines the emission area EMA of each of the pixel PXL and adjacent pixels PXL and may be, for example, a pixel definition film. In the process of supplying (or inserting) the light-emitting elements LD, the first bank BNK1 may define each emission area EMA to which the light-emitting elements LD may be supplied. The emission area EMA of the pixel PXL may be defined by the first bank BNK1 so that a mixed solution (for example, ink) including a desired amount and/or type of the light-emitting elements LD may be supplied (input) to the emission area EMA.

The first bank BNK1 may be provided to include at least one light blocking material and/or a reflective material (or a scattering material) to prevent light leakage defects in which light leaks between the pixel PXL and the pixels PXL adjacent thereto. The first bank BNK1 may include a transparent material (or substance). Examples of the transparent material may include a polyamide resin, a polyimide-based resin, and the like, but the disclosure is not limited thereto. A reflective material layer may be separately provided and/or formed on the first bank BNK1 to further improve the efficiency of light emitted from the pixel PXL.

The first bank BNK1 may include at least an opening exposing components positioned below the first bank BNK1 in the pixel area PXA. The emission area EMA of the pixel PX and the opening of the first bank BNK1 may correspond to each other.

An electrode separation area ESA may be positioned in the non-emission area NEA of each pixel PXL. The electrode separation area ESA may be an area in which first and second alignment electrodes ALE1 and ALE2 in each pixel PXL may be separated from first and second alignment electrodes ALE1 and ALE2 provided to pixels PXL arranged in the same pixel column.

The pixel PXL may include the pixel electrodes PE provided in the emission area EMA, the light-emitting elements LD electrically connected to the pixel electrodes PE, and alignment electrodes ALE provided at positions corresponding to the pixel electrodes PE. For example, a first pixel electrode PE1, a second pixel electrode PE2, a third pixel electrode PE3, a fourth pixel electrode PE4, the light-emitting elements LD, and first to third alignment electrodes ALE1, ALE2, and ALE3 may be disposed in the emission area EMA. The number, shape, size, and arrangement structure of each of the pixel electrodes PE and/or the alignment electrodes ALE vary according to the structure of the pixel PXL (or the emission component EMU).

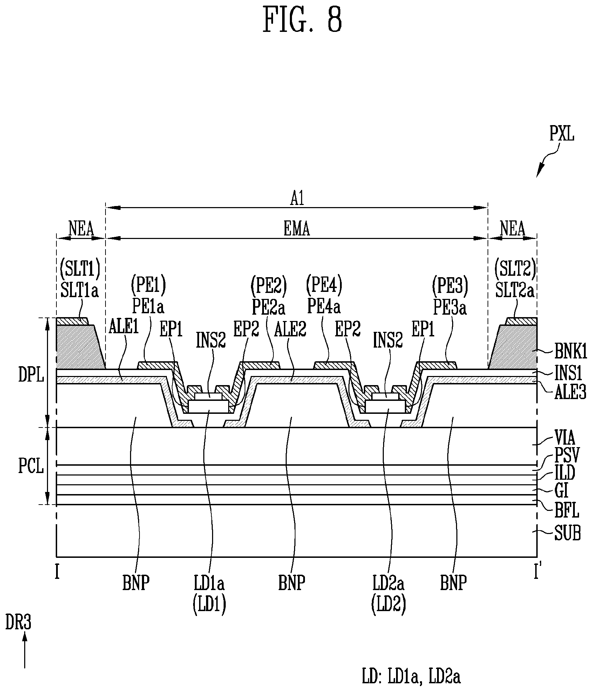

With respect to a surface of the substrate SUB on which the pixel PXL may be provided, the alignment electrodes ALE, the light-emitting elements LD, and the pixel electrodes PE may be sequentially provided, but the disclosure is not limited thereto. A stacked structure of the pixel PXL will be described below with reference to FIGS. 8 to 11.

The alignment electrodes ALE may be positioned at least in the emission area EMA, may be spaced apart from each other in the first direction DR1 in the emission area EMA, and may each extend in the second direction DR2. The alignment electrodes ALE may include the first alignment electrode ALE1, the second alignment electrode ALE2, and the third alignment electrode ALE3 arranged in the first direction DR1. The first, second, and third alignment electrodes ALE1, ALE2, and ALE3 may be arranged to be spaced apart from each other.

The first alignment electrode ALE1 may be separated from a first floating pattern FTP1 after the light-emitting elements LD may be supplied and aligned in the emission area EMA. Specifically, before the light-emitting elements LD may be aligned in each emission area EMA, the first alignment electrode ALE1 and the first floating pattern FTP1 may be integral with each other to constitute a first alignment line for aligning the light-emitting elements LD. The first floating pattern FTP1 may be electrically connected to a first alignment line through a third contact hole CH3. For example, the first alignment line may be a first power line (see "PL1" in FIG. 5). After an alignment process of the light-emitting elements LD is completed, the first alignment line may be cut in the electrode separation area ESA positioned around the first floating pattern FTP1 to divide the first alignment line into the first alignment electrodes ALE1 and the first floating patterns FTP1. The first alignment line may be cut in the electrode separation area ESA between adjacent pixel rows to separate the first alignment electrodes ALE1 of adjacent pixels PXL. The first alignment electrode ALE1 may be electrically connected to some components of the pixel circuit PXC through a first contact hole CH1. For example, the first alignment electrode ALE1 may be electrically connected to first and third transistors T1 and T3 of the pixel circuit PXC.

The second alignment electrode ALE2 may be separated from a second floating pattern FTP2 after the light-emitting elements LD may be supplied and aligned in the emission area EMA. Specifically, before the light-emitting elements LD may be aligned in each emission area EMA, the second alignment electrode ALE2 and the second floating pattern FTP may be integral with each other to constitute a second alignment line for aligning the light-emitting elements LD. The second floating pattern FTP2 may be electrically connected to a second alignment signal line through a sixth contact hole CH6. After an alignment process of the light-emitting elements LD is completed, the second alignment line may be cut in the electrode separation area ESA positioned around the second floating pattern FTP2 to divide the second alignment line into the second alignment electrodes ALE2 and the second floating patterns FTP2. The second alignment line may be cut in the electrode separation area ESA between adjacent pixel rows to separate the second alignment electrodes ALE2 of adjacent pixels PXL.

The third alignment electrode ALE3 may be electrically connected to a second power line (see "PL2" in FIG. 5) through a second contact hole CH2 regardless of before or after the light-emitting elements LD are aligned. Accordingly, the third alignment electrode ALE3 may receive an alignment signal from the second power line PL2 before the light-emitting elements LD are aligned and may receive a voltage of a second driving power source VSS from the second power line PL2 after the light-emitting elements LD are aligned.

Each of the first alignment electrode ALE1, the second alignment electrode ALE2, and the third alignment electrode ALE3 may be used as alignment lines for receiving signals (for example, an alignment signal) before the light-emitting elements LD may be aligned in the emission area EMA of each pixel PXL and aligning the light-emitting elements LD.

The first, second, and third alignment electrodes ALE1, ALE2, and ALE3 may be provided in a bar shape with a certain width at least in the emission area EMA, but the disclosure is not limited thereto. The first, second, and third alignment electrodes ALE1, ALE2, and ALE3 may or may not have a curved portion in the non-emission area NEA, and the shape and/or size thereof in the remaining areas except the emission area EMA is not particularly limited and may be variously changed.

At least two light-emitting elements LD may be aligned in the emission area EMA (or the pixel area PXA). The light-emitting elements LD may be disposed between the first alignment electrode ALE1 and the second alignment electrode ALE2 and between the second alignment electrode ALE2 and the third alignment electrode ALE3. In a plan view, each of the light-emitting elements LD may include a first end portion EP1 and a second end portion EP2 positioned at both end portions (or opposite to each other) in a longitudinal direction, for example, in the first direction DR1. A second semiconductor layer (see "13" in FIG. 1) including a p-type semiconductor layer may be positioned at the first end portion EP1 (or a p-type end portion), and a first semiconductor layer (see "11" in FIG. 1) including an n-type semiconductor layer may be positioned at the second end portion EP2 (or an n-type end portion). The light-emitting elements LD may be electrically connected in parallel between the first alignment electrode ALE1 and the second alignment electrode ALE2 and between the second alignment electrode ALE2 and the third alignment electrode ALE3.

The light-emitting elements LD may be spaced apart from each other and may be aligned substantially parallel to each other. A separation distance between the light-emitting elements LD is not particularly limited. Multiple light-emitting elements LD may be disposed adjacent to each other to form a group, and multiple other light-emitting elements LD may be spaced a certain interval apart from each other to form a group, may have a non-uniform density, and may be aligned in a direction.

The light-emitting elements LD may be input (or supplied) to the pixel area PXA (or the emission area EMA) through an inkjet printing method, a slit coating method, or various other methods. For example, the light-emitting elements LD may be mixed in a volatile solvent and input (or supplied) to the pixel area PXA through an inkjet printing method or a slit coating method.

The light-emitting elements LD may include a first light-emitting element LD1 and a second light-emitting element LD2.

The first light-emitting element LD1 may be aligned between the first alignment electrode ALE1 and a left side of the second alignment electrode ALE2 and may be electrically connected to the first pixel electrode PE1 and the second pixel electrode PE2. The second light-emitting element LD2 may be aligned between the third alignment electrode ALE3 and a right side of the second alignment electrode ALE2 and may be electrically connected to the third pixel electrode PE3 and the fourth pixel electrode PE4.

Multiple first light-emitting elements LD1 and multiple second light-emitting elements LD2 may be provided. The first end portion EP1 of each of the first light-emitting elements LD1 may be electrically connected to the first pixel electrode PE1 (or a first electrode EL1), and the second end portion EP2 of each of the first light-emitting elements LD1 may be electrically connected to the second pixel electrode PE2 (or a second electrode EL2). The first end portion EP1 of each of the second light-emitting elements LD2 may be electrically connected to the third pixel electrode PE3 (or the first electrode EL1), and the second end portion EP2 of each of the second light-emitting elements LD2 may be electrically connected to the fourth pixel electrode PE4 (or the second electrode EL2).

The first light-emitting elements LD1 may be electrically connected in parallel with each other between the first pixel electrode PE1 and the second pixel electrode PE2, and the second light-emitting elements LD2 may be electrically connected in parallel with each other between the third pixel electrode PE3 and the fourth pixel electrode PE4.

Pixel electrodes PE may be provided in the emission area EMA of the pixel PXL and may be provided at positions corresponding to at least one alignment electrode ALE and the light-emitting elements LD.

The pixel electrodes PE may include the first pixel electrode PE1, the second pixel electrode PE2, the third pixel electrode PE3, and the fourth pixel electrode PE4 that may be spaced apart from each other. The first pixel electrode PE1, the second pixel electrode PE2, the fourth pixel electrode PE4, and the third pixel electrode PE3 may be sequentially disposed in the first direction DR1 at least in the emission area EMA.

The first pixel electrode PE1 may be formed on the first alignment electrode ALE1. The first pixel electrode PE1 may be electrically connected to the first end portion EP1 of each of the first light-emitting elements LD1 so that the first end portion EP1 of each of the first light-emitting elements LD1 may be electrically connected to each other. The first pixel electrode PE1 may have a bar shape that may extend in the second direction DR2 and may have a certain width in the first direction DR1, but the disclosure is not limited thereto.

The second pixel electrode PE2 may be formed on the left side of the second alignment electrode ALE2. The second pixel electrode PE2 may be electrically connected to the second end portion EP2 of each of the first light-emitting elements LD1 so that the second end portion EP2 of each of the first light-emitting elements LD1 may be electrically connected to each other. The second pixel electrode PE2 may have a bar shape that may extend in the second direction DR2 and may have a certain width in the first direction DR1, but the disclosure is not limited thereto.

The third pixel electrode PE3 may be formed on the right side of the second alignment electrode ALE2. The third pixel electrode may be electrically connected to the first end portion EP1 of each of the second light-emitting elements LD2 so that the first end portion EP1 of each of the second light-emitting elements LD2 may be electrically connected to teach other. The third pixel electrode PE3 may have a bar shape that may extend in the second direction DR2 and may have a certain width in the first direction DR1, but the disclosure is not limited thereto.

The fourth pixel electrode PE4 may be formed on the third alignment electrode ALE3. The fourth pixel electrode may be electrically connected to the second end portion EP2 of each of the second light-emitting elements LD2 so that the second end portion EP2 of each of the second light-emitting elements LD2 may be electrically connected to each other. The fourth pixel electrode PE4 may have a bar shape that may extend in the second direction DR2 and may have a certain width in the first direction DR1, but the disclosure is not limited thereto.

The second pixel electrode PE2 and the third pixel electrode PE3 may be electrically connected through a contact electrode CNE. For example, the second pixel electrode PE2 and the third pixel electrode PE3 may be electrically connected through the contact electrode CNE positioned in the non-emission area NEA. The contact electrode CNE and the second pixel electrode PE2 and/or the third pixel electrode PE3 may be integral with each other and may be electrically and/or physically connected to the second and third pixel electrodes PE2 and PE3.

The first light-emitting elements LD1 may be electrically connected in series to the second light-emitting elements LD2 through the contact electrode CNE. The first pixel electrode PE1 and the second pixel electrode PE2 may form a first stage SET1 together with the first light-emitting elements LD1 electrically connected in parallel therebetween. The third pixel electrode PE3 and the fourth pixel electrode PE4 may form a second stage SET2 together with the second light-emitting elements LD2 electrically connected in parallel therebetween. The first pixel electrode PE1 may be the first electrode EL1 of the first stage SET1, and the second pixel electrode PE2 may be the second electrode EL2 of the first stage SET1. The third pixel electrode PE3 may be the first electrode EL1 of the second stage SET2, and the fourth pixel electrode PE4 may be the second electrode EL2 of the second stage SET2. The first pixel electrode PE1 may be an anode of the emission component EMU, and the fourth pixel electrode PE4 may be a cathode of the emission component EMU.

The first pixel electrode PE1 may be in contact with the first alignment electrode ALE1 through a fourth contact hole CH4 in the non-emission area NEA and may be electrically connected to the first alignment electrode ALE1. The pixel circuit PXC, the first alignment electrode ALE1, and the first pixel electrode PE1 may be electrically connected through the first contact hole CH1 and the fourth contact hole CH4. In the above-described example, it has been described that the first alignment electrode ALE1 and the first pixel electrode PE1 may be in direct contact with each other and electrically connected to each other through the fourth contact hole CH4, but the disclosure is not limited thereto. In order to prevent defects due to the material characteristics of the first alignment electrode ALE1, the first pixel electrode PE1 may not be in direct contact with the first alignment electrode ALE1 and may be in direct contact with the pixel circuit PXC to be electrically connected to the pixel circuit PXC.

The fourth pixel electrode PE4 may be in contact with the third alignment electrode ALE3 through a fifth contact hole CH5 in the non-emission area NEA and may be electrically connected to the third alignment electrode ALE3. The second power line PL2, the third alignment electrode ALE3, and the fourth pixel electrode PE4 may be electrically connected through the second contact hole CH2 and the fifth contact hole CH5. In the above-described example, it has been described that the third alignment electrode ALE3 and the fourth pixel electrode PE4 may be in direct contact with each other and electrically connected to each other through the fifth contact hole CH5, but the disclosure is not limited thereto. In order to prevent defects due to the material characteristics of the third alignment electrode ALE3, the fourth pixel electrode PE4 may not be direct contact with the third alignment electrode ALE3 and may be in direct contact with the second power line PL2 to be electrically connected to the second power line PL2.

Between the first pixel electrode PE1 and the fourth pixel electrode PE4, the first light-emitting element LD1 and the second light-emitting element LD2 may be electrically connected in series through the contact electrode CNE and the second and third pixel electrodes PE2 and PE3. In this way, the emission component EMU of the pixel PXL may be formed by connecting the light-emitting elements (LD) aligned in the emission area EMA in a series/parallel mixed structure.

The pixel PXL may further include at least a sub-electrode electrically connected to the pixel electrode PE positioned at an edge (or an outer peripheral portion) of the emission area EMA. For example, the pixel PXL may include at least a sub-electrode electrically connected to the first pixel electrode PE1 and the third pixel electrode PE3 positioned at the edge of the emission area EMA. The sub-electrode may include a first sub-electrode SLT1 electrically connected to the first pixel electrode PE1 and a second sub-electrode SLT2 electrically connected to the third pixel electrode PE3.

The first sub-electrode SLT1 and the first pixel electrode PE1 may be formed by a same process and may be integral with each other, but the disclosure is not limited thereto. The first sub-electrode SLT1 may be positioned in the non-emission area NEA and may overlap the first bank BNK1. The second sub-electrode SLT2 and the third pixel electrode PE3 may be integral with each other, but the disclosure is not limited thereto. The second sub-electrode SLT2 may be positioned in the non-emission area NEA and may overlap the first bank BNK1.

The emission area EMA of the pixel PXL is divided into a first area A1, a second area A2, and a third area A3 in the second direction DR2. In a plan view, the first area A1 is an upper area of the emission area EMA, the second area A2 is a lower area of the emission area EMA, and the third area A3 is a middle area of the emission area EMA.

The first pixel electrode PE1 may include a 1-1 pixel electrode PE1a (or a first portion) positioned in the first area A1 and a 1-2 pixel electrode PE1b (or a second portion) positioned in the second area A2. The first pixel electrode PE1 may not be positioned in the third area A3. The first pixel electrode PE1 may be electrically disconnected in the third area A3. In other words, the first and second portions of the first pixel electrode are not electrically connected to one another in the third area A3. The 1-1 pixel electrode PE1a and the 1-2 pixel electrode PE1b may be spaced apart from each other in the third area A3.

The second pixel electrode PE2 may include a 2-1 pixel electrode PE2a (or a first portion) positioned in the first area A1, a 2-2 pixel electrode PE2b (or a second portion) positioned in the second area A2, and a 2-3 pixel electrode PE2c (or a third portion) positioned in the third area A3. The 2-3 pixel electrode PE2c may be positioned between the 2-1 pixel electrode PE2a and the 2-2 pixel electrode PE2b and may connect the 2-1 pixel electrode PE2a and the 2-2 pixel electrode PE2b. The 2-3 pixel electrode PE2c may have a narrower width (be narrower) than the 2-1 and 2-2 pixel electrodes PE2a and PE2b in the first direction DR1. Designing the width of the 2-3 pixel electrode PE2c (for example, the width in the first direction DR1) to be narrow may be to make laser cutting easier in a process of repairing dark spot defects of the pixel PXL. However, the disclosure is not limited thereto, and the 2-3 pixel electrode PE2c may have the same width as the 2-1 and 2-2 pixel electrodes PE2a and PE2b.

The third pixel electrode PE3 may include a 3-1 pixel electrode PE3a (or a first portion) positioned in the first area A1 and a 3-2 pixel electrode PE3b (a second portion) positioned in the second area A2. The third pixel electrode PE3 may not be positioned in the third area A3. The third pixel electrode PE3 may be electrically disconnected in the third area A3. In other words, the first and second portions of the third pixel electrode are not electrically connected to one another in the third area A3. The 3-1 pixel electrode PE3a and the 3-2 pixel electrode PE3b may be spaced apart from each other in the third area A3.

The fourth pixel electrode PE4 may include a 4-1 pixel electrode PE4a (or a first portion) positioned in the first area A1, a 4-2 pixel electrode PE4b (or a second portion) positioned in the second area A2, and a 4-3 pixel electrode PE4c (or a third portion) positioned in the third area A3. The 4-3 pixel electrode PE4c may be positioned between the 4-1 pixel electrode PE4a and the 4-2 pixel electrode PE4b and may connect the 4-1 pixel electrode PE4a and the 4-2 pixel electrode PE4b. The 4-3 pixel electrode PE4c may have a narrower width than the 4-1 and 4-2 pixel electrodes PE4a and PE4b in the first direction DR1. Designing the width of the 4-3 pixel electrode PE4c (for example, the width in the first direction DR1) to be narrow may be to make laser cutting easier in a process of repairing dark spot defects of the pixel PXL. However, the disclosure is not limited to this, and the 4-3 pixel electrode PE4c may have the same width as the 4-1 and 4-2 pixel electrodes PE4a and PE4b.

At least the first pixel electrode PE1 and third pixel electrode PE3 positioned at an outer peripheral portion of the emission area EMA may be electrically disconnected in the third area A3. In other words, the first pixel electrode PE1 is divided into portions and the respective portions are separated from one another and not electrically connected to one another in the third area A3. The same applies to the third pixel electrode PE3. The second pixel electrode PE2 and the fourth pixel electrode PE4 positioned at an inner portion of the emission area EMA may each include the third portion connecting the first portion and the second portion.

The first sub-electrode SLT1 may include a 1-1 sub-electrode SLT1a electrically connected to the 1-1 pixel electrode PE1a, a 1-2 sub-electrode SLT1b electrically connected to the 1-2 pixel electrode PE1b, and a 1-3 sub-electrode SLT1c electrically connecting the 1-1 sub-electrode SLT1a and the 1-2 sub-electrode SLT1b. The 1-1 sub-electrode SLT1a may be positioned in the non-emission area NEA corresponding to the first area A1, and the 1-2 sub-electrode SLT1b may be positioned in the non-emission area NEA corresponding to the second area A2, and the 1-3 sub-electrode SLT1c may be positioned in the non-emission area NEA corresponding to the third area A3. The 1-3 sub-electrode SLT1c may have a narrower width than the 1-1 and 1-2 sub-electrodes SLT1a and SLT1b in the first direction DR1. Designing the width of the 1-3 sub-electrode SLT1c (for example, the width in the first direction DR1) to be narrow may be to make laser cutting easier in a process of repairing dark spot defects of the pixel PXL. However, the disclosure is not limited to this, and the 1-3 sub-electrode SLT1c may have the same width as the 1-1 and 1-2 sub-electrodes SLT1a and SLT1b.

The second sub-electrode SLT2 may include a 2-1 sub-electrode SLT2a electrically connected to the 3-1 pixel electrode PE3a, a 2-2 sub-electrode SLT2b electrically connected to the 3-2 pixel electrode PE3b, and a 2-3 sub-electrode SLT2c electrically connecting the 2-1 sub-electrode SLT2a and the 2-2 sub-electrode SLT2b. The 2-1 sub-electrode SLT2a may be positioned in the non-emission area NEA corresponding to the first area A1, the 2-2 sub-electrode SLT2b may be positioned in the non-emission area NEA corresponding to the second area A2, and the 2-3 sub-electrode SLT2c may be positioned in the non-emission area NEA corresponding to the third area A3. The 2-3 sub-electrode SLT2c may have a narrower width than the 2-1 and 2-2 sub-electrodes SLT2a and SLT2b in the first direction DR1. Designing the width of the 2-3 sub-electrode SLT2c (for example, the width in the first direction DR1) to be narrow may be to make laser cutting easier in a process of repairing dark spot defects of the pixel PXL. However, the disclosure is not limited thereto, and the 2-3 sub-electrode SLT2c may have the same width as the 2-1 and 2-2 sub-electrodes SLT2a and SLT2b.

The first light-emitting elements LD1 may include (1a)^{th} light-emitting elements LD1a positioned in the first area A1 and (1b_th light-emitting elements LD1b positioned in the second area A2. The second light-emitting elements LD2 may include (2a)^{th} light-emitting elements LD2a positioned in the first area A1 and (2b)^{th} light-emitting elements LD2b positioned in the second area A2.

The (1a)^{th} light-emitting elements LD1a may be electrically connected to the 1-1 pixel electrode PE1a and the 2-1 pixel electrode PE2a. The first end portion EP1 of each of the (1a)^{th} light-emitting elements LD1a may be electrically connected to the 1-1 pixel electrode PE1a (or the first electrode EL1), and the second end portion EP2 of each of the (1a)^{th} light-emitting elements LD1a may be electrically connected to the 2-1 pixel electrode PE2a (or the second electrode EL2).

The (1b)^{th} light-emitting elements LD1b may be electrically connected to the 1-2 pixel electrode PE1b and the 2-2 pixel electrode PE2b. The first end portion EP1 of each of the (1b)^{th} light-emitting elements LD1b may be electrically connected to the 1-2 pixel electrode PE1b (or the first electrode EL1), and the second end portion EP2 of each of the (1b)^{th} light-emitting elements LD1b may be electrically connected to the 2-2 pixel electrode PE2b (or the second electrode EL2).

The (2a)^{th} light-emitting elements LD2a may be electrically connected to the 3-1 pixel electrode PE3a and the 4-1 pixel electrode PE4a. The first end portion EP1 of each of the (2a)^{th} light-emitting elements LD2a may be electrically connected to the 3-1 pixel electrode PE3a (or the first electrode EL1), and the second end portion EP2 of each of the (2a)^{th} light-emitting elements LD2a may be electrically connected to the 4-1 pixel electrode PE4a (or the second electrode EL2).

The (2b)^{th} light-emitting elements LD2b may be electrically connected to the 3-2 pixel electrode PE3b and the 4-2 pixel electrode PE4b. The first end portion EP1 of each of the (2b)^{th} light-emitting elements LD2b may be electrically connected to the 3-2 pixel electrode PE3b (or the first electrode EL1), and the second end portion EP2 of each of the (2b) light-emitting elements LD2b may be electrically connected to the 4-2 pixel electrode PE4b (or the second electrode EL2).

Hereinafter, a stacked structure (or a cross-sectional structure) of a pixel PXL according to the above-described example will be described with reference to FIGS. 8 to 11.

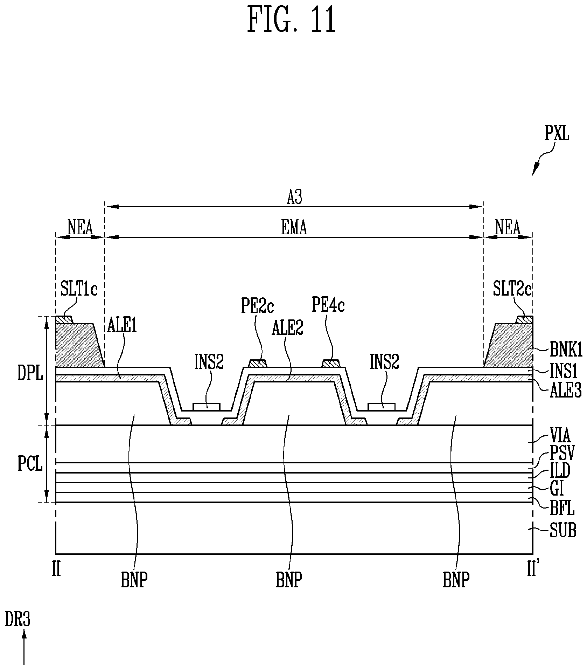

FIGS. 8 to 10 are schematic cross-sectional views taken along line I-I' of FIG. 6. FIG. 11 is a schematic cross-sectional view taken along lines II-II' of FIG. 6.

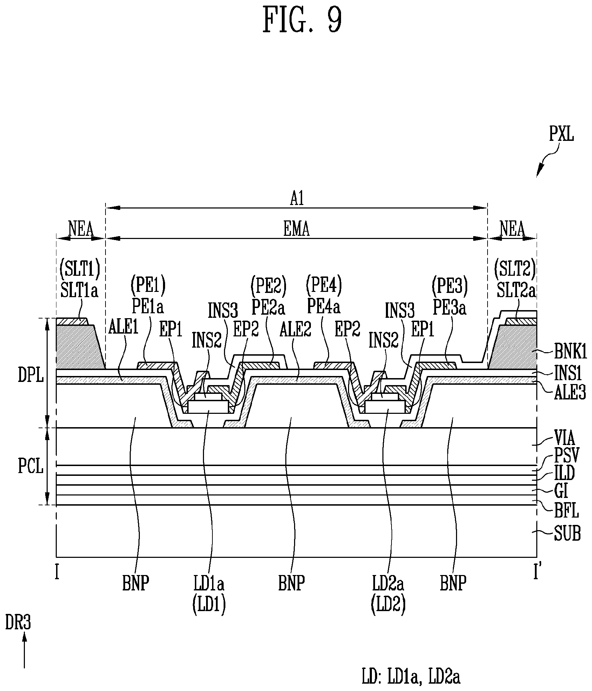

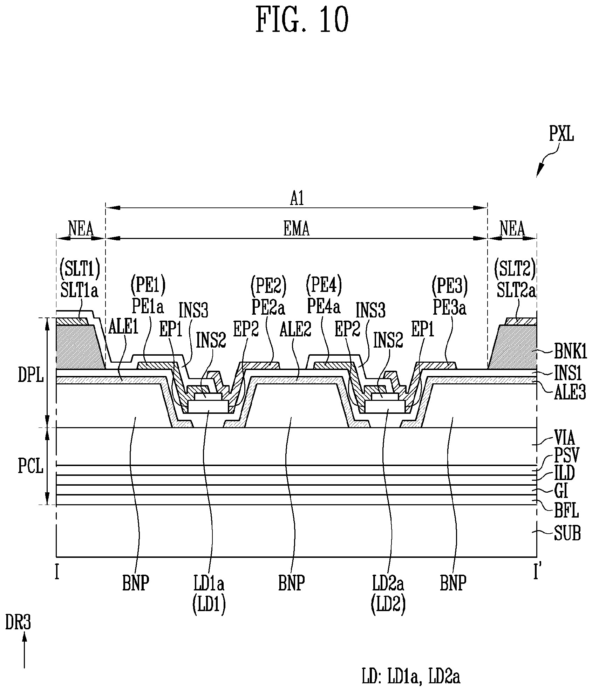

FIGS. 9 and 10 are modified examples of FIG. 8 in relation to an operation of forming pixel electrodes PE and the presence or absence of a third insulating layer INS3. For example, FIG. 9 illustrates an example in which, after 2-1 and 3-1 pixel electrodes PE2a and PE3a and a third insulating layer INS3 are formed, 1-1 and 4-1 pixel electrodes PE1a and PE4a may be formed. FIG. 10 illustrates an example in which, after the 1-1 and 4-1 pixel electrodes PE1a and PE4a and the third insulating layer INS3) are formed, the 2-1 and 3-1 pixel electrodes PE2a and PE3a may be formed.

In FIGS. 8 to 11, each electrode may be illustrated as a single layer electrode, and each insulating layer may be illustrated as a single layer insulating layer to simplify and illustrate the stacked structure (or the cross-sectional structure) of the pixel PXL, but the disclosure is not limited thereto.

Referring to FIGS. 1 to 11, the pixel PXL may include a substrate SUB, a pixel circuit layer PCL, and a display element layer DPL.

The pixel circuit layer PCL and the display element layer DPL may be disposed on a surface of the substrate SUB to overlap each other. For example, a display area DA of the substrate SUB may include the pixel circuit layer PCL disposed on a surface of the substrate SUB and the display element layer DPL disposed on the pixel circuit layer PCL. However, the mutual positions of the pixel circuit layer PCL and the display element layer DPL on the substrate SUB may vary. In the case that the pixel circuit layer PCL and the display element layer DPL are separated into separate layers and overlap each other, a sufficient layout space may be secured for forming a pixel circuit (see "PXC" in FIG. 5) and an emission component (see "EMU" in FIG. 5) in a plan view.

The substrate SUB may include a transparent insulating material to transmit light. The substrate SUB may be a rigid substrate or a flexible substrate.

In each pixel area PXA of the pixel circuit layer PCL, circuit elements constituting the pixel circuit PXC of the corresponding pixel PXL and certain signal lines electrically connected to the circuit elements may be disposed. In each pixel area PXA of the display element layer DPL, alignment electrodes ALE, light-emitting elements LD, and pixel electrodes PE, which constitute the emission component EMU of the corresponding pixel PXL, may be disposed.

The pixel circuit layer PCL may include one or more insulating layers in addition to the circuit elements and the signal lines. For example, the pixel circuit layer PCL may include a buffer layer BFL, a gate insulating layer GI, an interlayer insulating layer ILD, a passivation layer PSV, and a via layer VIA which may be sequentially stacked on each other on the substrate SUB in a third direction DR3.

The buffer layer BFL may be entirely disposed on the substrate SUB. The buffer layer BFL may prevent impurities from diffusing into transistors T included in the pixel circuit PXC. The buffer layer BFL may be an inorganic insulating film including an inorganic material. The buffer layer BFL may include at least one of silicon nitride (SiNₓ), silicon oxide (SiOₓ), silicon oxynitride (SiOₓN_{y}), and aluminum oxide (AlOₓ), but the disclosure is not limited thereto. The buffer layer BFL may be provided as a single layer but may also be provided as a multi-layer including at least a double layer. In the case that the buffer layer BFL is provided as the multi-layer, respective layers may be made of a same material or may be made of different materials. The buffer layer BFL may be omitted according to a material and process conditions of the substrate SUB.

The gate insulating layer GI may be entirely disposed on the buffer layer BFL. The gate insulating layer GI and the buffer layer BFL may include a same material, or the gate insulating layer GI may include a suitable material (or selected from) among materials exemplified as constituent materials of the buffer layer BFL. For example, the gate insulating layer GI may be an inorganic insulating film including an inorganic material.

The interlayer insulating layer ILD may be entirely provided and/or formed on the gate insulating layer GI. The interlayer insulating layer ILD and the buffer layer BFL may include a same material, or may include at least one suitable material (or selected from) among the materials exemplified as the constituent materials of the buffer layer BFL.

The passivation layer PSV may be entirely provided and/or formed on the interlayer insulating layer ILD. The passivation layer PSV may include the and the buffer layer BFL or may include at least one suitable material (or selected from) among the materials exemplified as the constituent materials of the buffer layer BFL.

The via layer VIA may be entirely provided and/or formed on the passivation layer PSV. The via layer VIA may be an inorganic insulating film including an inorganic material or an organic insulating film including an organic material. The inorganic insulating film may include, for example, at least one of silicon oxide (SiOₓ), silicon nitride (SiNₓ), silicon oxynitride (SiOₓN_{y}), and aluminum oxide (AlOₓ). The organic insulating film may include, for example, at least one of a polyacrylate-based resin, an epoxy-based resin, a phenolic resin, a polyamide-based resin, a polyimide-based resin, an unsaturated polyester-based resin, a poly-phenylene ether-based resin, a poly-phenylene sulfide-based resin, and a benzocyclobutene resin.

The via layer VIA may include multiple contact holes. For example, the via layer VIA may be partially opened to include first, second, third, and sixth contact holes CH1, CH2, CH3, and CH6.

The display element layer DPL may be disposed on the via layer VIA.

Components of the emission component EMU may be disposed in the display element layer DPL. For example, a bank pattern BNP, the alignment electrodes ALE, a first bank BNK1, the light-emitting elements LD, and the pixel electrodes PE may be disposed in the display element layer DPL.

The bank pattern BNP may be positioned on the via layer VIA. For example, the bank pattern BNP may protrude in the third direction DR3 on a surface of the via layer VIA. An area of the alignment electrodes ALE disposed on the bank pattern BNP may protrude in the third direction DR3 (or a thickness direction of the substrate SUB).

The bank pattern BNP may include an inorganic insulating film including an inorganic material or an organic insulating film including an organic material. The bank pattern BNP may include a single layer organic insulating film and/or a single layer inorganic insulating film, but the disclosure is not limited thereto. The bank pattern BNP may be provided in the form of a multi-layer in which at least one organic insulating film and at least one inorganic insulating film may be stacked on each other. However, a material of the bank pattern BNP is not limited to the above-described, and the bank pattern BNP may include a conductive material (or substance).

The bank pattern BNP may be positioned below each of first to third alignment electrodes ALE1, ALE2, and ALE3 at least in an emission area EMA and may overlap a corresponding alignment electrode ALE.

The bank pattern BNP may have a trapezoidal cross section of which a width becomes narrower upward from a surface (or an upper surface) of the via layer VIA in the third direction DR3, but the disclosure is not limited thereto.

The bank pattern BNP may be used as a reflective member. For example, the bank pattern BNP may be used as a reflective member which, together with the alignment electrode ALE disposed thereon, guides light emitted from each light-emitting element LD toward an image display direction of a display device (see "DD" n FIG. 3) to improve the luminance efficiency of the pixel PXL.

The first, second, and third alignment electrodes ALE1, ALE2, and ALE3 may be positioned on the bank pattern BNP.

The first, second, and third alignment electrodes ALE1, ALE2, and ALE3 may be disposed to be coplanar with each other and may have a same thickness in the third direction DR3. The first, second, and third alignment electrodes ALE1, ALE2, and ALE3 may be formed simultaneously or consecutively through the same process.

The first, second, and third alignment electrodes ALE1, ALE2, and ALE3 may be made of a material having reflectance to allow light emitted from the light-emitting elements LD to travel in the image display direction (or front direction) of the display device DD. For example, the first, second, and third alignment electrodes ALE1, ALE2, and ALE3 may be made of a conductive material (or substance). The conductive material may include an opaque metal suitable for reflecting light emitted from the light-emitting elements LD in the image display direction of the display device DD.

Each of the first, second, and third alignment electrodes ALE1, ALE2, and ALE3 may be formed as a single layer, but the disclosure is not limited thereto. Each of the first, second, and third alignment electrodes ALE1, ALE2, and ALE3 may be provided and/or formed as a multi-layer in which at least two materials of metals, alloys, conductive oxides, and conductive polymers may be stacked on each other. In order to reduce or minimize distortion caused by a signal delay in the case that a signal is transmitted to both end portions of each of the light-emitting elements LD, for example, to first and second end portions EP1 and EP2, each of the first, second, and third alignment electrodes ALE1, ALE2, and ALE3 may be formed as a multi-layer including at least a double layer.

In the case that the first, second, and third alignment electrodes ALE1, ALE2, and ALE3 may be made of a conductive material having reflectance, light emitted from the first and second end portions EP1 and EP2 of each of the light-emitting elements LD may further travel in the image display direction of the display device DD.

A first insulating layer INS1 may be disposed on the first, second, and third alignment electrodes ALE1, ALE2, and ALE3.

The first insulating layer INS1 may be disposed on the alignment electrodes ALE and the via layer VIA. The first insulating layer INS1 may be partially opened to expose components positioned below the first insulating layer INS1 at least in a non-emission area NEA. For example, the first insulating layer INS1 may be partially opened to include a fourth contact hole CH4 through which at least an area thereof in the non-emission area NEA may be removed to expose an area of the first alignment electrode ALE1, and a fifth contact hole CH5 through which another area thereof in the non-emission area NEA may be removed to expose another area of the third alignment electrode ALE3.

The first insulating layer INS1 may be formed as an inorganic insulating film made of an inorganic material. The first insulating layer INS1 may be provided as a single layer or a multi-layer.

The first bank BNK1 may be positioned on the first insulating layer INS1.

The first bank BNK1 may be disposed on the first insulating layer INS1 at least in the non-emission area NEA, but the disclosure is not limited thereto. The first bank BNK1 may be formed between adjacent pixels PXL to surround the emission area EMA of each pixel PXL and constitute a pixel definition film that defines the emission area EMA of the corresponding pixel PXL. The first bank BNK1 may be a dam structure which, in an operation of supplying the light-emitting elements LD to the emission area EMA, prevents a solution (or ink) mixed with the light-emitting elements LD from flowing into the emission area EMA of the adjacent pixels PXL or performs control such that a certain amount of solution may be supplied to each emission area EMA.

The first bank BNK1 and the bank pattern BNP may be formed through different processes and provided to not be coplanar with each other, but the disclosure is not limited thereto. The first bank BNK1 and the bank pattern BNP may be formed through different processes and provided to be coplanar with each other or may be formed through a same process and provided to be coplanar with each other.

The light-emitting elements LD may be supplied and aligned in the emission area EMA of the pixel PXL in which the first insulating layer INS1 and the first bank BNK1 may be formed. For example, the light-emitting elements LD may be supplied (or input) to the emission area EMA through an inkjet printing method or the like. The light-emitting elements LD may be aligned between the alignment electrodes ALE by an electric field generated by a signal (or an alignment signal) applied to each of the alignment electrodes ALE. For example, the light-emitting elements LD may be aligned between the first alignment electrode ALE1 and the second alignment electrode ALE2 and between the second alignment electrode ALE2 and the third alignment electrode ALE3.

The light-emitting elements LD may include first light-emitting elements LD1 and second light-emitting elements LD2.

The first light-emitting elements LD1 include (1a)^{th} light-emitting elements LD1a positioned in a first area A1 of the emission area EMA and (1b)^{th} light-emitting elements LD1b positioned in a second area A2 of the emission area EMA. The first light-emitting elements LD1 may each include the first end portion EP1 overlapping the first alignment electrode ALE1 and the second end portion EP2 overlapping the second alignment electrode ALE2.

The second light-emitting elements LD2 may include (2a)^{th} light-emitting elements LD2a positioned in the first area A1 of the emission area EMA and (2b)^{th} light-emitting elements LD2b positioned in the second area A2 of the emission area EMA. The second light-emitting elements LD2 may include a first end portion EP1 overlapping the third alignment electrode ALE3 and a second end portion EP2 overlapping the second alignment electrode ALE2.

A second insulating layer INS2 (or an insulating pattern) may be disposed on each of the (1a)^{th}, (1b)^{th}, (2a)^{th}, and (2b)^{th} light-emitting elements LD1a, LD1b, LD2a, and LD2b.

The second insulating layer INS2 may be positioned on the (1a)^{th}, (1b)^{th}, (2a)^{th}, and (2b)^{th} light-emitting elements LD1a, LD1b, LD2a, and LD2b to partially cover an outer peripheral surface (or a surface) of the (1a)^{th}, (1b)^{th}, (2a)^{th}, and (2b)^{th} light-emitting elements LD1a, LD1b, LD2a, and LD2b, thereby externally exposing the first end portion EP1 and the second end portion EP2 of each of the (1a)^{th}, (1b)^{th}, (2a)^{th}, and (2b)^{th} light-emitting elements LD1a, LD1b, LD2a, and LD2b.

The second insulating layer INS2 may include an inorganic insulating film including an inorganic material or an organic insulating film. For example, the second insulating layer INS2 may include an inorganic insulating film suitable for protecting an active layer (see "12" of FIG. 1) of each of the (1a)^{th}, (1b)^{th}, (2a)^{th}, and (2b)^{th} light-emitting elements LD1a, LD1b, LD2a, and LD2b. However, the disclosure is not limited thereto, and according to design conditions of the display device DD (or a display panel DP) to which the (1a)^{th}, (1b)^{th}, (2a)^{th}, and (2b)^{th} light-emitting elements LD1a, LD1b, LD2a, and LD2b are included, the second insulating layer INS2 may be provided as an organic insulating film including an organic material. The second insulating layer INS2 may be provided as a single layer or a multi-layer.

In the case that an empty gap may be between the (1a)^{th}, (1b)^{th}, (2a)^{th}, and (2b)^{th} light-emitting elements LD1a, LD1b, LD2a, and LD2b and the first insulating layer INS1 before the second insulating layer INS2 may be formed, the empty gap may be filled with the second insulating layer INS2 during a process of forming the second insulating layer INS2.

By forming the second insulating layer INS2 on the aligned light-emitting elements LD, it may be possible to prevent the light-emitting elements LD from deviating from aligned positions thereof.

On both end portions of the light-emitting elements LD that may not be covered by the second insulating layer INS2, for example, the first and second end portions EP1 and EP2, different electrodes may be formed among first to fourth pixel electrodes PE1, PE2, PE3, and PE4. For example, the 1-1 pixel electrode PE1a may be formed on the first end portion EP1 of the (1a)^{th} light-emitting element LD1a, and the 2-1 pixel electrode PE1b may be formed on the second end portion EP2 of the (1a)^{th} light-emitting element LD1b. The 1-2 pixel electrode PE1b may be formed on the first end portion EP1 of the (1b)^{th} light-emitting element LD1b, and a 2-2 pixel electrode PE2b may be formed on the second end portion EP2 of the (1b)^{th} light-emitting element LD1b. The 3-1 pixel electrode PE3a may be formed on the first end portion EP1 of the (2a)^{th} light-emitting element LD2a, and the 4-1 pixel electrode PE4a may be formed on the second end portion EP2 of the (2a)^{th} light-emitting element LD2a. A 3-2 pixel electrode PE3b may be formed on the first end portion EP1 of the (2b)^{th} light-emitting element LD2b, and a 4-2 pixel electrode PE4b may be formed on the second end portion EP2 of the (2b)^{th} light-emitting element LD2b.

In the example of FIG. 8, the first, second, third, and fourth pixel electrodes PE1, PE2, PE3, and PE4 may be formed simultaneously or sequentially through a same process and may be disposed on the same layer. In the case that the pixel electrodes PE disposed on the first end portion EP1 and the second end portion EP2 of each light-emitting element LD may be disposed to be coplanar with each other and formed simultaneously or sequentially, a manufacturing process of the pixel PXL may be simplified, and process efficiency may be improved. A first sub-electrode SLT1 electrically connected to the first pixel electrode PE1 and a second sub-electrode SLT2 electrically connected to the third pixel electrode PE3 may be formed simultaneously or sequentially through the same process as the fourth pixel electrodes PE1, PE2, PE3, and PE4.

The pixel electrodes PE disposed on the first end portion EP1 and the second end portion EP2 of each light-emitting element LD may be formed through different processes and may be disposed to not be coplanar with each other. For example, in the example of FIG. 9, the 2-1 pixel electrode PE2a (or the second pixel electrode PE2) and the 3-1 pixel electrode PE3a (or the third pixel electrode PE3 may be formed first. The 2-1 pixel electrode PE2a may be in direct contact with the second end portion EP2 of the (1a)^{th} light-emitting element LD1a to be electrically connected to the (1a)^{th} light-emitting element LD1a. The 3-1 pixel electrode PE3a may be in direct contact with the first end portion EP1 of the (2a)^{th} light-emitting element LD2a to be electrically connected to the (2a)^{th} light-emitting element LD2a. In a process of forming the 3-1 pixel electrode PE3a, the 2-1 sub-electrode SLT2a (or the second sub-electrode SLT2) may be formed simultaneously. Thereafter, the third insulating layer INS3 may be formed to cover the 2-1 pixel electrode PE2a and the 3-1 pixel electrode PE3a. The third insulating layer INS3 may include an inorganic insulating film made of an inorganic material or an organic insulating film made of an organic material. The third insulating layer INS3 may be formed as a single layer or a multi-layer. The 1-1 pixel electrode PE1a (or the first pixel electrode PE1) and the 4-1 pixel electrode PE4a (or the fourth pixel electrode PE4) may be formed on the third insulating layer INS3. The 1-1 pixel electrode PE1a may be in direct contact with the first end portion EP1 of the (1a)^{th} light-emitting element LD1a to be electrically connected to the (1a)^{th} light-emitting element LD1a. The 4-1 pixel electrode PE4a may be in direct contact with the second end portion EP2 of the (2a)^{th} light-emitting element LD2a to be electrically connected to the (2a)^{th} light-emitting element LD2a. In a process of forming the 1-1 pixel electrode PE1a, the 1-1 sub-electrode SLT1a (or the first sub-electrode SLT1) may be formed simultaneously.

In the example of FIG. 10, the 1-1 pixel electrode PE1a (or the first pixel electrode PE1), the 1-1 sub-electrode SLT1a (or the first sub-electrode SLT1a), and the 4-1 pixel electrode PE4a (or the fourth pixel electrode PE4) may be formed first on the second insulating layer INS2. Thereafter, the third insulating layer INS3 may be formed to cover the 1-1 and 4-1 pixel electrodes PE1a and PE4a and the 1-1 sub-electrode SLT1a, and the 2-1 pixel electrode PE2a (or the second pixel electrode PE2), the 3-1 pixel electrode PE3a (or the third pixel electrode PE3), and the 2-1 sub-electrode SLT2a (or the second sub-electrode SLT2) may be formed on the third insulating layer INS3.

As in FIGS. 9 and 10, in the case that the pixel electrodes PE disposed on the first end portion EP1 and the second end portion EP2 of each light-emitting element LD are disposed to not be coplanar with each other, the pixel electrodes PE may be separated more stably. Accordingly, electrical stability between the first end portion EP1 and the second end portion EP2 of the light-emitting elements LD may be further secured.

The first, second, third, and fourth pixel electrodes PE1, PE2, PE3, and PE4 may each be made of various transparent conductive materials. For example, each of the first, second, third, and fourth pixel electrodes PE1, PE2, PE3, and PE4 may include at least one of various transparent conductive materials such as indium tin oxide, indium zinc oxide, indium tin zinc oxide, aluminum zinc oxide, gallium zinc oxide, zinc tin oxide, and gallium tin oxide and may be implemented to be substantially transparent or semi-transparent to satisfy certain transmittance. Accordingly, light emitted from the first and second end portions EP1 and EP2 of the light-emitting elements LD may pass through the first, second, third, and fourth pixel electrodes PE1, PE2, PE3, and PE4 to be emitted to the outside of the display panel DP.

At least one overcoat layer (for example, a layer for planarizing an upper surface of the display element layer DPL) may be further disposed on the pixel electrodes PE.

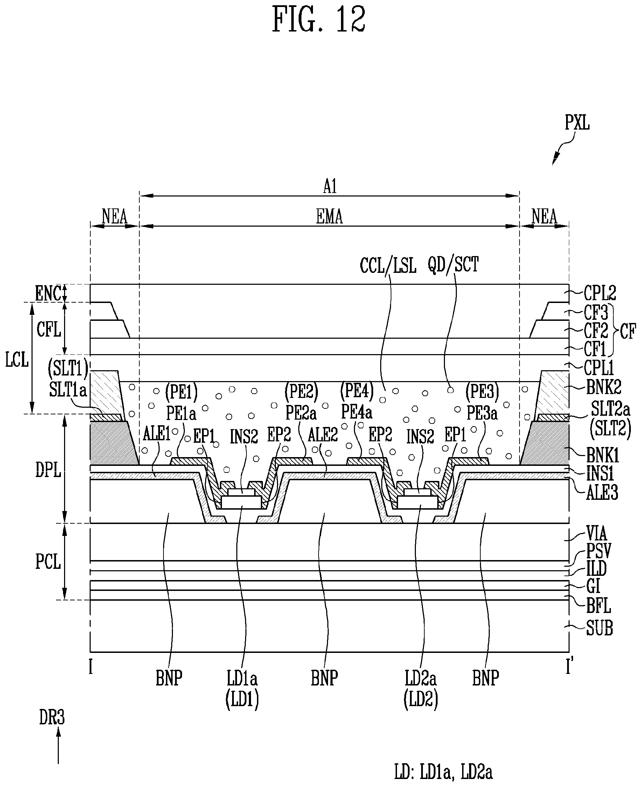

An optical layer may be optionally disposed on the display element layer DPL. For example, the optical layer may include a color conversion layer and a color filter layer that convert light emitted from the light-emitting elements LD into light with excellent color reproducibility. The optical layer will be described below with reference to FIG. 12.

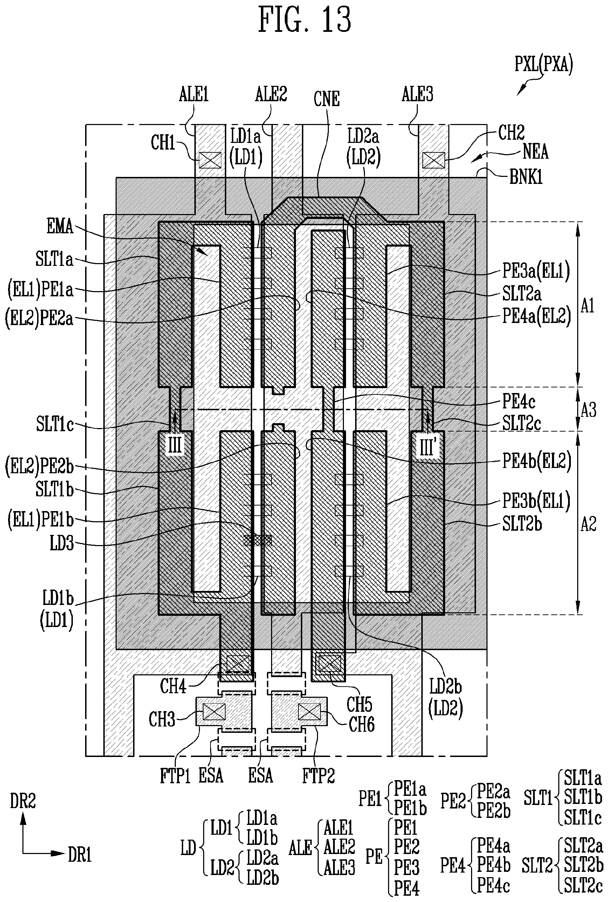

After the light-emitting elements LD are aligned in the emission area EMA and the pixel electrodes PE electrically connected to the light-emitting elements LD are formed, an inspection may be performed to determine whether dark spot defects may be in the pixel PXL. In the case that a defective light-emitting element may be in the emission area EMA, the light-emitting elements LD electrically connected in parallel with the defective light-emitting element may not be turned on. The defects may include a defect of the light-emitting element LD itself, a short circuit of the pixel electrodes PE positioned at both end portions of the light-emitting element LD, and the like, but the disclosure is not limited thereto. In the case that the light-emitting elements LD are not turned on in the above-described inspection, and thus the pixels PXL are darkened, a process of repairing the defective light-emitting element may be performed. For example, by removing an area of an electrode electrically connected to an end portion of the defective light-emitting element through laser cutting, the electrode may be floated to perform a repair such that the remaining light-emitting elements (LD) that may not be electrically connected to the electrode may be normally turned on. A detailed description regarding the repair of the defective light-emitting element will be provided below with reference to FIGS. 13 to 15.

FIG. 12 illustrates a pixel PXL is a schematic cross-sectional view corresponding to line I-I' of FIG. 6.

In relation to FIG. 12, in order to avoid redundant description, differences from the above-described example will be described.

Referring to FIGS. 1 to 12, the pixel PXL may include a substrate SUB, a pixel circuit layer PCL, a display element layer DPL, a color filter layer CFL, and an encapsulation layer ENC.

The display element layer DPL may include a bank pattern BNP, first to third alignment electrodes ALE1, ALE2, and ALE3, a first bank BNK1, light-emitting elements LD, and first to fourth pixel electrodes PE1, PE2, PE3, and PE4. The display element layer DPL may further include a second bank BNK2 disposed on the first bank BNK1, a color conversion layer CCL disposed on the first to fourth pixel electrodes PE1, PE2, PE3, and PE4, and a first capping layer CPL1 disposed on the color conversion layer CCL and the second bank BNK2.

The second bank BNK2 may be disposed on the first bank BNK1 in a non-emission area NEA of the pixel PXL. The second bank BNK2 may surround an emission area EMA of the pixel PXL and may be a dam structure that finally defines the emission area EMA by defining a position at which the color conversion layer CCL may be to be supplied.

The second bank BNK2 may include a light blocking material. For example, the second bank BNK2 may be a black matrix, but is not limited thereto. The second bank BNK2 may be provided to include at least one light blocking material and/or a reflective material to allow light emitted from the color conversion layer CCL to further travel in an image display direction of a display device DD, thereby improving luminous efficiency of the color conversion layer CCL.

The color conversion layer CCL may include color conversion particles QD corresponding to a specific color. For example, the color conversion layer CCL may include the color conversion particles QD that convert first color light emitted from the light-emitting elements LD into second color light (specific color light or light with an excellent color reproduction rate). In the case that the pixel PXL is a red pixel (or a red subpixel), the color conversion layer CCL of the pixel PXL may include the color conversion particles QD of red quantum dots that convert the first color light emitted from the light-emitting elements LD into the second color light (for example, red light).

In the case that the pixel PXL is a green pixel (or a green subpixel), the color conversion layer CCL of the pixel PXL may include the color conversion particles QD of green quantum dots that convert the first color light emitted from the light-emitting elements LD into the second color light (for example, green light).

In the case that the pixel PXL is a blue pixel (or a blue subpixel), the color conversion layer CCL of the pixel PXL may include the color conversion particles QD of blue quantum dots that convert the first color light emitted from the light-emitting elements LD into the second color light (for example, blue light). In the case that the pixel (PXL is a blue pixel (or a blue subpixel), a light scattering layer LSL including light scattering particles SCT may be provided instead of the color conversion layer CCL including the color converting particles QD. For example, in the case that the light-emitting elements LD emit blue light, the pixel PXL may include the light scattering layer LSL including the light scattering particles SCT. The light scattering layer LSL described above may be omitted. In the case that the pixel PXL is a blue pixel (or a blue subpixel), a transparent polymer may be provided instead of the color conversion layer CCL.

The first capping layer CPL1 may be disposed on the color conversion layer CCL and the second bank BNK2.

The first capping layer CPL1 may be entirely provided in the display area DA in which the pixel PXL may be positioned to cover the second bank BNK2 and the color conversion layer CCL.

The first capping layer CPL1 may be an inorganic insulating film including an inorganic material. The first capping layer CPL1 may include at least one of silicon nitride (SiNₓ), silicon oxide (SiOₓ), silicon oxynitride (SiOₓN_{y}), and aluminum oxide (AlOₓ). The first capping layer CPL1 may entirely cover the second bank BNK2 and the color conversion layer CCL to block external moisture or oxygen from entering the color conversion layer CCL.

The first capping layer CPL1 may have an approximately flat surface while alleviating a step difference caused by components disposed below the first capping layer CPL1. For example, the first capping layer CPL1 may include an organic insulating film including an organic material, but the disclosure is not limited thereto. The first capping layer CPL1 may be a common layer provided in common to the display area DA.

The color filter layer CFL may be disposed on the first capping layer CPL1.

The color filter layer CFL may include a color filter CF corresponding to the emission area EMA of each pixel PXL. For example, the color filter layer CFL may include a first color filter CF1 disposed on the color conversion layer CCL of a pixel PXL (hereinafter referred to as "first pixel"), a second color filter CF2 disposed on the color conversion layer of an adjacent pixel (hereinafter referred to as "second pixel") adjacent to the first pixel PXL, and a third color filter CF3 disposed on the color conversion layer of an adjacent pixel adjacent to the second pixel.

The first, second, and third color filters CF1, CF2, and CF3 may be disposed in the non-emission area NEA to overlap each other and may be used as light blocking members to block light interference between adjacent pixels PXL. Each of the first, second, and third color filters CF1, CF2, and CF3 may include a color filter material that selectively transmits the color light converted in the corresponding color conversion layer CCL. For example, the first color filter CF1 may be a red color filter, the second color filter CF2 may be a green color filter, and the third color filter CF3 may be a blue color filter, but the disclosure is limited thereto.

The encapsulation layer ENC may be disposed on the color filter layer CFL.

The encapsulation layer ENC may include a second capping layer CPL2. The second capping layer CPL2 may be an inorganic insulating film including an inorganic material or an organic insulating film including an organic material. The second capping layer CPL2 may entirely cover components positioned below the second capping layer CPL2 to block external moisture or humidity from flowing into the color filter layer CFL and the display element layer DPL. The second capping layer CPL2 may be used as a planarization layer that alleviates a step difference caused by components of the color filter layer CFL and the display element layer DPL positioned below the second capping layer CPL2.

The second capping layer CPL2 may be formed as a multi-layer. For example, the second capping layer CPL2 may include at least two layers of inorganic insulating films and at least one layer of an organic insulating film interposed between the at least two layers of inorganic insulating films. However, the constituent materials and/or structure of the second capping layer CPL2 may be changed in various ways. At least one overcoat layer, a filler layer, and/or another substrate may be further disposed on the second capping layer CPL2.

In the pixel PXL described above, the color conversion layer CCL and the color filter layer CFL may be disposed on the light-emitting element LD through a continuous process to emit light with excellent color reproducibility through the color conversion layer CCL and the color filter layer CFL, thereby improving luminous efficiency.

The color conversion layer CCL and the color filter layer CFL may be formed on a surface of a base substrate (not shown) through a continuous process to constitute an upper substrate which may be separate from the substrate SUB on which the first to fourth pixel electrodes PE1, PE2, PE3, and PE4 may be disposed. The upper substrate may be coupled to the display element layer DPL including the first to fourth pixel electrodes PE1, PE2, PE3, and PE4 through an intermediate layer made of an insulating and adhesive material.

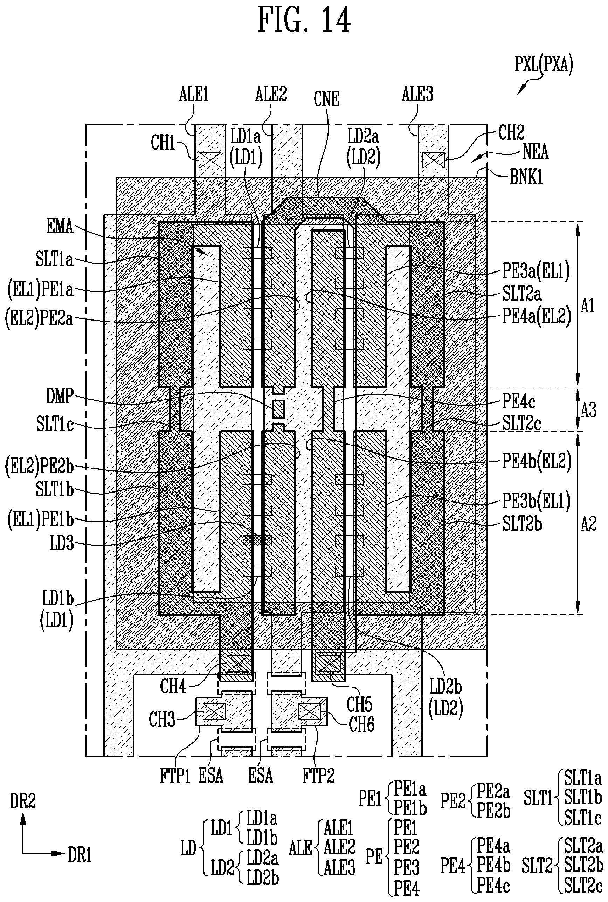

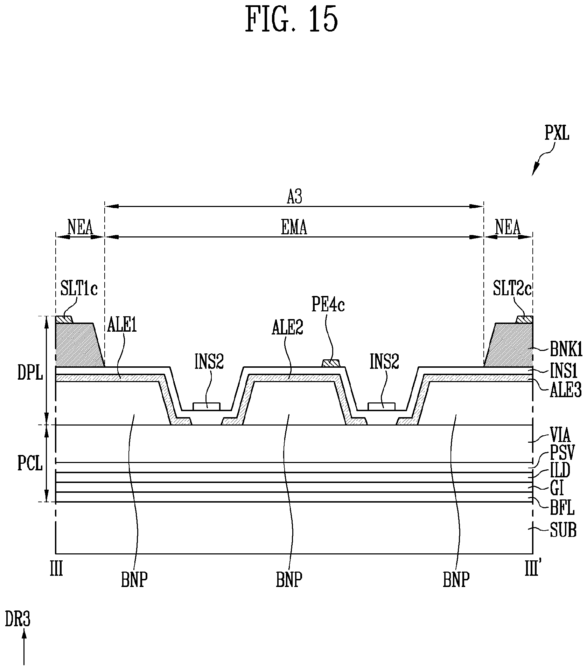

FIGS. 13 and 14 are schematic plan views illustrating a state of the pixel PXL of FIG. 6 after repairing. FIG. 15 is a schematic cross-sectional view taken along line III-III' of FIG. 13.

Referring to FIGS. 5, 6, and 13 to 15, the pixel PXL may include an emission component (see "EMU" in FIG. 5) formed by electrically connecting a first stage (see "SET1" in FIG. 5) and a second stage (see "SET2" in FIG. 5) in series.

The first stage SET1 may include first light-emitting elements LD1 electrically connected in parallel between a first pixel electrode PE1 and a second pixel electrode (see "PE2" in FIG. 6), and the second stage SET2 may include second light-emitting elements LD2 electrically connected in parallel between a third pixel electrode PE3 and a fourth pixel electrode PE4. In a plan view (or viewed from above), the first stage SET1 may be positioned at a first side (for example, a left side) of an emission area EMA, and the second stage SET2 may be positioned at a second side (for example, a right side) of the emission area EMA.

The pixel PXL may include a third light-emitting element LD3 electrically connected between a 1-2 pixel electrode PE1b (or a first electrode EL1) and a 2-2 pixel electrode PE2b (or a second electrode EL2). The third light-emitting element LD3 may be a defective light-emitting element. In the case that the third light-emitting element LD3 is present in the pixel PXL, light-emitting elements LD electrically connected in parallel with the third light-emitting element LD3, for example, the first light-emitting elements LD1, may not be driven normally. An area of the emission area EMA in which the first light-emitting elements LD1 are disposed (for example, the first side of the emission area EMA in which the first stage SET1 is positioned) may not be turned on. Accordingly, the pixel PXL has a luminous efficiency of about 50% because only another area of the emission area EMA (for example, the second side of the emission area EMA in which the second stage SET2 may be positioned) may be turned on. In the case that the pixel PXL has a luminous efficiency of about 50%, the pixel PXL may be determined to have a dark spot defect, and thus even the normally operating light-emitting elements LD may be unnecessarily wasted. Accordingly, a repair process may be performed to reduce the possibility of dark spot defects in the pixel PXL, thereby preventing undesirable waste of the normally operating light-emitting elements LD.

The repair process described above may be performed by checking a position of the defective light-emitting element and using a process such as laser cutting, but the disclosure is not limited thereto. In the repair process, for example, a portion of a second pixel electrode PE2, which may be an electrode electrically connected to the third light-emitting element LD3 (or the defective light-emitting element), may be removed using a laser, thereby repairing a dark spot defective pixel PXL. Specifically, in the case that the position of the third light-emitting element LD3, which is the defective light-emitting element, is specified, a 2-3 pixel electrode (see "PE2c" in FIG. 6) may be removed from the second pixel electrode PE2 using a laser to float a 2-2 pixel electrode PE2b electrically connected to the third light-emitting element LD3. Through the above-described repair process, a 2-1 pixel electrode PE2a and the 2-2 pixel electrode PE2b of the second pixel electrode PE2 may be electrically separated. The 2-1 pixel electrode PE2a and the 2-2 pixel electrode PE2b, which may be positioned in the same column in a second direction DR2 and constitute the second pixel electrode PE2, may be electrically disconnected in a third area A3 of the emission area EMA. Accordingly, (1a)^{th} light-emitting elements LD1a electrically connected to the 2-1 pixel electrode PE2a may be electrically separated from the third light-emitting element LD3 (or the defective light-emitting element) electrically connected to the 2-2 pixel electrode PE2b so that the (1a)^{th} light-emitting elements LD1a may be driven normally.

As described above, in the case that the (1a)^{th} light-emitting elements LD1a may be driven normally, even an area of the emission area EMA in which the (1a)^{th} light-emitting elements LD1a may be positioned (for example, an upper end portion of the first side of the emission area EMA) may be turned on. Except for the third light-emitting element LD3 and (1b)^{th} light-emitting element LD1b electrically connected to the floating 2-2 pixel electrode PE2b, the remaining light-emitting elements LD may be turn on, thereby improving the luminous efficiency of the pixel PXL determined to have a dark spot defect. For example, in the case that all the (1a)^{th} light-emitting elements LD1a and the second light-emitting elements LD2 may be turned on, the pixel PXL that is determined to have a dark spot defect may have a luminous efficiency of about 75%. Accordingly, the pixel PXL may be repaired, thereby improving the reliability of a display device (see "DD" in FIG. 3).

According to the above-described example, the possibility of dark spot defects in the pixel PXL may be reduced, and undesirable waste of the normally operating light-emitting elements LD may be prevented.

In the above-described repair process, a 2-3 pixel electrode PE2c of the second pixel electrode PE2 may be completely removed using a laser, but the disclosure is not limited thereto. As shown in FIG. 14, the 2-1 pixel electrode PE2a may be electrically disconnected from the 2-3 pixel electrode PE2c and the 2-2 pixel electrode PE2b may be electrically disconnected from the 2-3 pixel electrode PE2c to form a floating dummy pattern DMP in the third area A3 of the emission area EMA. The dummy pattern DMP may be a portion of the 2-3 pixel electrode PE2c remaining in the third area A3. The dummy pattern DMP may be electrically separated from each of the 2-1 pixel electrode PE2a and the 2-2 pixel electrode PE2b.

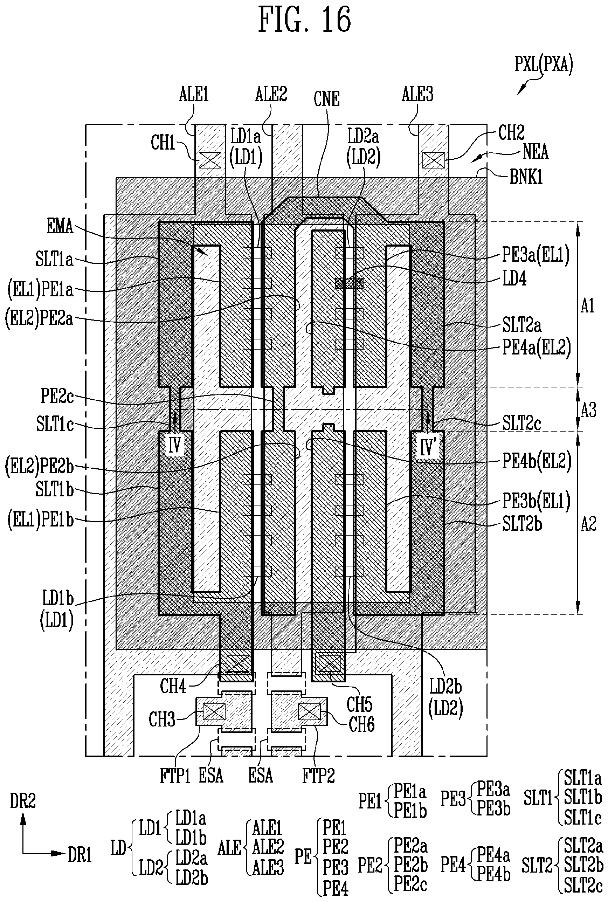

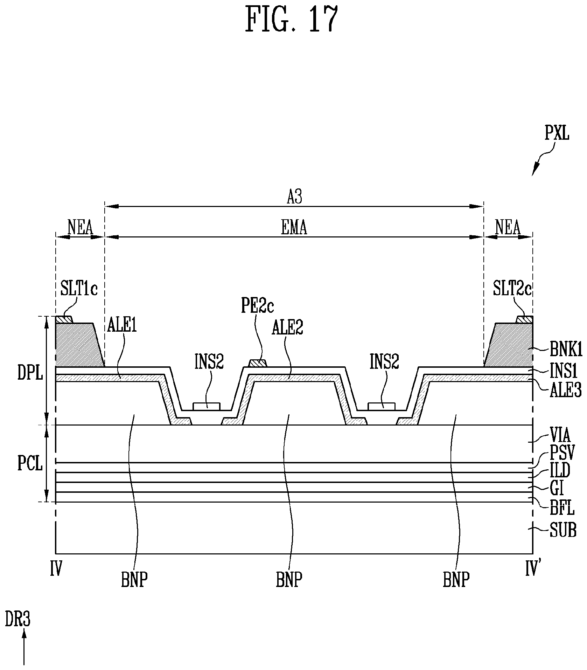

FIG. 16 is a schematic plan view illustrating a state of the pixel PXL of FIG. 6 after repairing. FIG. 17 is a schematic cross-sectional view taken along lines IV-IV' of FIG. 16.

With regard to FIGS. 16 and 17, differences from the above-described examples will be described in order to avoid redundant description.

Referring to FIGS. 5, 6, 16, and 17, the pixel PXL may include a fourth light-emitting element LD4 electrically connected between a 3-1 pixel electrode PE3a (or a first electrode EL1) and a 4-1 pixel electrode PE4a (or a second electrode EL2). The fourth light-emitting element LD4 may be a defective light-emitting element. In the case that the fourth light-emitting element LD4 is present in the pixel PXL, light-emitting elements LD electrically connected in parallel with the fourth light-emitting element LD4, for example, second light-emitting elements LD2, may not be driven normally. An area of an emission area EMA in which the second light-emitting elements LD2 are disposed (for example, a second side of the emission area EMA in which a second stage SET2 is positioned) may not be turned on. Accordingly, the pixel PXL has a luminous efficiency of about 50% because only another area of the emission area EMA (for example, a first side of the emission area EMA in which first-light-emitting elements LD1 of a first stage SET1 may be positioned) may be turned on. In the case that the pixel PXL has a luminous efficiency of about 50%, the pixel PXL may be determined to have a dark spot defect, and thus even the normally operating light-emitting elements LD may be unnecessarily wasted. Accordingly, a repair process may be performed to reduce the possibility of dark spot defects in the pixel PXL, thereby preventing undesirable waste of the normally operating light-emitting elements LD.

A portion of a fourth pixel electrode (see "PE4" in FIG. 6), which may be an electrode electrically connected to the fourth light-emitting element LD4 (or the defective light-emitting element), may be removed using a laser, thereby repairing a dark spot defective pixel PXL. Specifically, in the case that a position of the fourth light-emitting element LD4, which is the defective light-emitting element, is specified, a 4-3 pixel electrode (see "PE4c" in FIG. 6) may be removed from the fourth pixel electrode PE4 using a laser to float a 4-1 pixel electrode PE4a electrically connected to the fourth light-emitting element LD4. Through the above-described repair process, the 4-1 pixel electrode PE4a and a 4-2 pixel electrode PE4b of the fourth pixel electrode PE4 may be electrically separated. The 4-1 pixel electrode PE4a and the 4-2 pixel electrode PE4b, which may be positioned in a same column in a second direction DR2 and constitute the fourth pixel electrode PE4, may be electrically disconnected in a third area A3 of the emission area EMA. Accordingly, (2b)^{th} light-emitting elements LD2b electrically connected to the 4-2 pixel electrode PE4b may be electrically separated from the fourth light-emitting element LD4 (or the defective light-emitting element) electrically connected to the 4-1 pixel electrode PE4a so that the (2b)^{th} light-emitting elements LD2b may be driven normally.

As described above, in the case that the (2b)^{th} light-emitting elements LD2b are driven normally, even an area of the emission area EMA in which the (2b)^{th} light-emitting elements LD2b may be positioned (for example, a lower end portion of a second side of the emission area EMA) may be turned on. Except for the fourth light-emitting element LD4 and (2a)^{th} light-emitting element LD2a electrically connected to the floating 4-1 pixel electrode PE4a, the remaining light-emitting elements LD may be turn on, thereby improving the luminous efficiency of the pixel PXL determined to have a dark spot defect. For example, in the case that all the first light-emitting elements LD1 and the (2b)^{th} light-emitting elements LD2b are turned on, the pixel PXL that may be determined to have a dark spot defect may have a luminous efficiency of about 75%. Accordingly, the pixel PXL may be repaired, thereby improving the reliability of a display device (see "DD" in FIG. 3).

According to the above-described, the possibility of dark spot defects in the pixel PXL may be reduced, and undesirable waste of the normally operating light-emitting elements LD may be prevented.

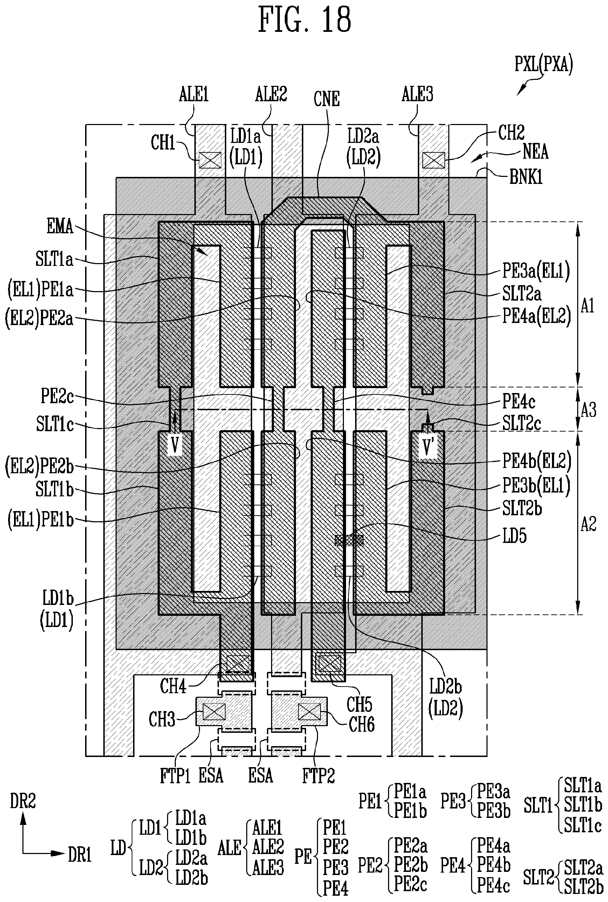

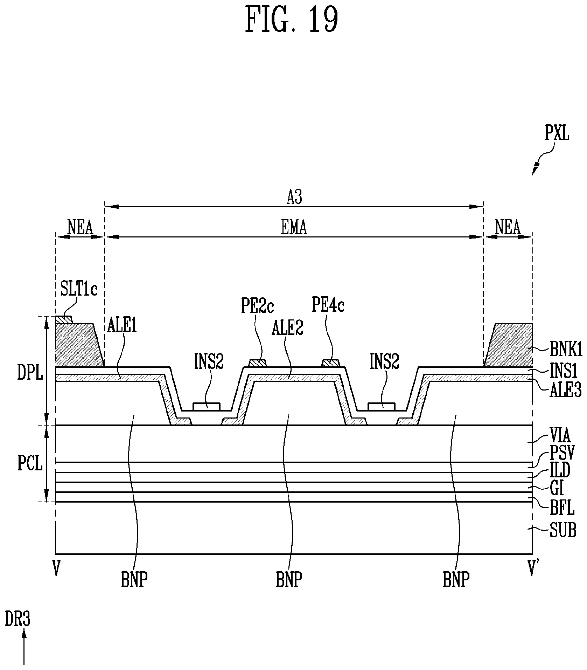

FIG. 18 is a schematic plan view illustrating a state of the pixel PXL of FIG. 6 after repairing. FIG. 19 is a schematic cross-sectional view taken along line V-V' of FIG. 18.

With regard to FIGS. 18 and 19, differences from the above-described examples will be described in order to avoid redundant description.

Referring to FIGS. 5, 6, 18, and 19, the pixel PXL may include a fifth light-emitting element LD5 electrically connected between a 3-2 pixel electrode PE3b (or a first electrode) and a 4-2 pixel electrode PE4b (or a second electrode). The fifth light-emitting element LD5 may be a defective light-emitting element. In the case that the fifth light-emitting element LD5 is present in the pixel PXL, light-emitting elements LD electrically connected in parallel with the fifth light-emitting element LD5, for example, second light-emitting elements LD2, may not be driven normally. An area of an emission area EMA in which the second light-emitting elements LD2 are disposed (for example, a second side of the emission area EMA in which a second stage SET2 is positioned) may not be turned on. Accordingly, the pixel PXL has a luminous efficiency of about 50% because only another area of the emission area EMA (for example, a first side of the emission area EMA in which light-emitting elements LD1 of a first stage SET1 may be positioned) may be turned on. In the case that the pixel PXL has a luminous efficiency of about 50%, the pixel PXL may be determined to have a dark spot defect, and thus even the normally operating light-emitting elements LD may be unnecessarily wasted. Accordingly, a repair process may be performed to reduce the possibility of dark spot defects in the pixel PXL, thereby preventing undesirable waste of the normally operating light-emitting elements LD.

A portion of a second sub-electrode SLT2, which may be an electrode electrically connected to the fifth light-emitting element LD5 (or the defective light-emitting element), may be removed using a laser, thereby repairing the pixel PXL. Specifically, in the case that a position of the fifth light-emitting element LD5, which is the defective light-emitting element, is specified, a 2-3 sub-electrode (see "SLT2c" in FIG. 6) may be removed from the second sub-electrode PE2 (see "SLT2" in FIG. 6) using a laser to float a 3-2 pixel electrode PE3b electrically connected to the fifth light-emitting element LD5. Through the above-described repair process, a 2-1 sub-electrode SLT2a and a 2-2 sub-electrode SLT2b, which may be positioned in the same column in a second direction DR2 and constitute the second sub-electrode SLT2, may be electrically disconnected in a non-emission area NEA corresponding to a third area A3 of the emission area EMA. Thus, a 3-1 pixel electrode PE3a electrically connected to the 2-1 sub-electrode SLT2a and the 3-2 pixel electrode PE3b electrically connected to the 2-2 sub-electrode SLT2b may be electrically separated. Accordingly, (2a)^{th} light-emitting elements LD2a electrically connected to the 3-1 pixel electrode PE3a may be electrically separated from the fifth light-emitting element LD5 (or the defective light-emitting element) electrically connected to the 3-2 pixel electrode PE3b so that the (2a)^{th} light-emitting elements LD2a may be driven normally.

As described above, in the case that the (2a)^{th} light-emitting elements LD2a are driven normally, even an area of the emission area EMA in which the (2a)^{th} light-emitting elements LD2a are positioned (for example, an upper end portion of a second side of the emission area EMA) may be turned on. Except for the fifth light-emitting element LD5 and (2b)^{th} light-emitting element LD2b electrically connected to the floating 3-2 pixel electrode PE3b, the remaining light-emitting elements LD may be turn on, thereby improving the luminous efficiency of the pixel PXL determined to have a dark spot defect. For example, in the case that all the first light-emitting elements LD1 and the (2a)^{th} light-emitting elements LD2a are turned on, the pixel PXL that is determined to have a dark spot defect may have a luminous efficiency of about 75%. Accordingly, the pixel PXL may be repaired, thereby improving the reliability of a display device (see "DD" in FIG. 3).

According to the above-described example, the possibility of dark spot defects in the pixel PXL may be reduced, thereby preventing undesirable waste of the normally operating light-emitting elements LD.

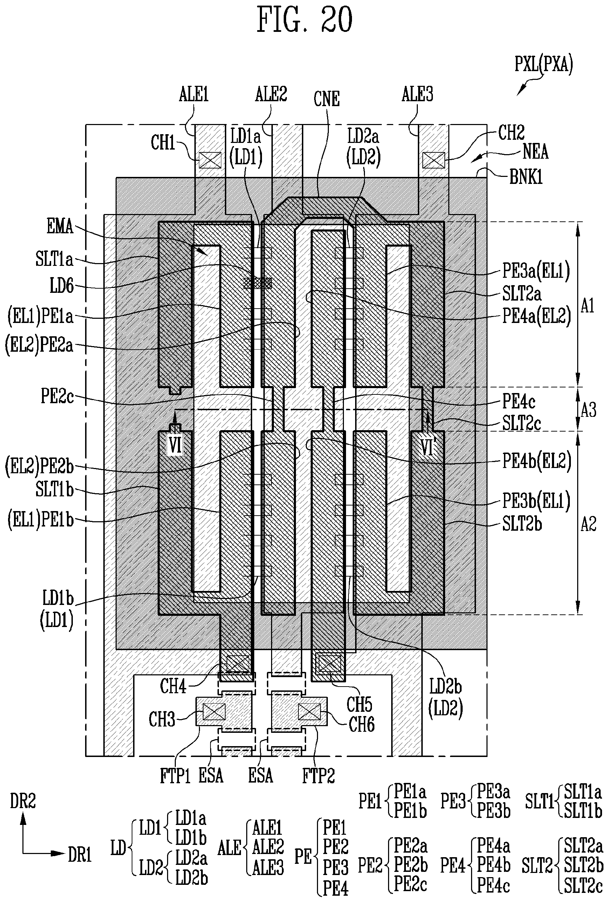

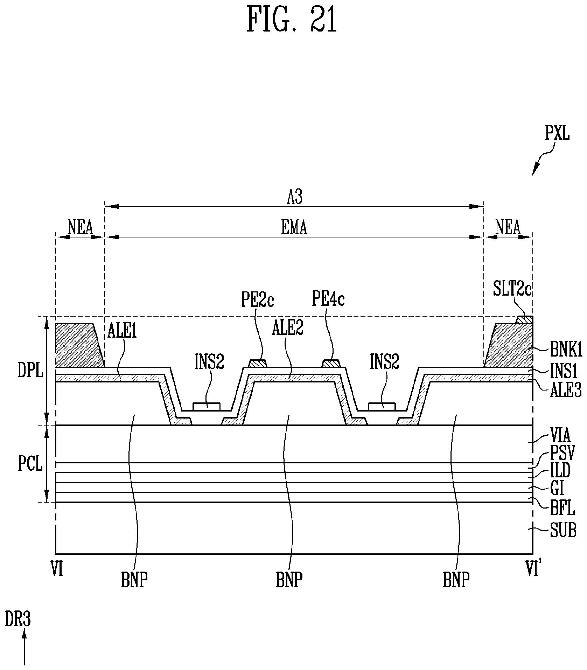

FIG. 20 is a schematic plan view illustrating a state of the pixel PXL of FIG. 6 after repairing. FIG. 21 is a schematic cross-sectional view taken along line VI-VI' of FIG. 20.

With regard to FIGS. 20 and 21, differences from the above-described examples will be described in order to avoid redundant description.

Referring to FIGS. 5, 6, 20, and 21, the pixel PXL may include a sixth light-emitting element LD6 electrically connected between a 1-1 pixel electrode PE1a (or a first electrode) and a 2-1 pixel electrode PE2a (or a second electrode). The sixth light-emitting element LD6 may be a defective light-emitting element. In the case that the sixth light-emitting element LD6 is present in the pixel PXL, light-emitting elements LD electrically connected in parallel with the sixth light-emitting element LD6, for example, first light-emitting elements LD1, may not be driven normally. An area of an emission area EMA in which the first light-emitting elements LD1 are disposed (for example, a first side of the emission area EMA in which a first stage SET1 is positioned) may not be turned on. Accordingly, the pixel PXL has a luminous efficiency of about 50% because only another area of the emission area EMA (for example, a second side of the emission area EMA in which second light-emitting elements of a second stage SET2 may be positioned) may be turned on. In the case that the pixel PXL has a luminous efficiency of about 50%, the pixel PXL may be determined to have a dark spot defect, and thus even the normally operating light-emitting elements LD may be unnecessarily wasted. Accordingly, in this example, a repair process may be performed to reduce the possibility of dark spot defects in the pixel PXL, thereby preventing undesirable waste of the normally operating light-emitting elements LD.

A portion of a first sub-electrode (see "SLT1" in FIG. 6), which may be an electrode electrically connected to the sixth light-emitting element LD6 (or the defective light-emitting element), may be removed using a laser, thereby repairing the pixel PXL. Specifically, in the case that a position of the sixth light-emitting element LD6, which is the defective light-emitting element, is specified, a 1-3 pixel electrode (see "SLT1c" in FIG. 6) may be removed from the first sub-electrode SLT1 using a laser to float a 1-1 pixel electrode PE1a electrically connected to the sixth light-emitting element LD6. Through the above-described repair process, a 1-1 sub-electrode SLT1a and a 1-2 sub-electrode SLT1b, which may be positioned in the same column in a second direction DR2 and constitute the first sub-electrode SLT1, may be electrically disconnected in a non-emission area NEA corresponding to a third area A3 of the emission area EMA. Thus, the 1-1 pixel electrode PE1a electrically connected to the 1-1 sub-electrode SLT2a and the 1-2 pixel electrode PE1b electrically connected to the 1-2 sub-electrode SLT1b may be electrically separated. Accordingly, (1b)^{th} light-emitting elements LD1b electrically connected to the 1-2 pixel electrode PE1b may be electrically separated from the sixth light-emitting element LD6 (or the defective light-emitting element) electrically connected to the 1-1 pixel electrode PE1a so that the (1b)^{th} light-emitting elements LD1b may be driven normally.

As described above, in the case that the (1b)^{th} light-emitting elements LD1b are driven normally, even an area of the emission area EMA in which the (12b)^{th} light-emitting elements LD1b may be positioned (for example, a lower end portion of a first side of the emission area EMA) may be turned on. Except for the sixth light-emitting element LD6 and (1a)^{th} light-emitting element LD1a electrically connected to the floating 1-1 pixel electrode PE1a, the remaining light-emitting elements LD may be turn on, thereby improving the luminous efficiency of the pixel PXL determined to have a dark spot defect. For example, in the case that all the (1b)^{th} light-emitting elements LD1b and the second light-emitting elements LD2 may be turned on, the pixel PXL that is determined to have a dark spot defect may have a luminous efficiency of about 75%. Accordingly, the pixel PXL may be repaired, thereby improving the reliability of a display device (see "DD" in FIG. 3).

According to the above-described example, the possibility of dark spot defects in the pixel PXL may be reduced, thereby preventing undesirable waste of the normally operating light-emitting elements LD.

According to a display device and a method of repairing the same according to embodiments, even in the case that a dark spot defect occurs in each pixel, the pixel can be readily repaired to improve the reliability of a display device.

According to a display device and a method of repairing the same according to embodiments, even in the case that a defective light-emitting element is disposed in each pixel, the pixel may be readily repaired, and each pixel may be driven normally using the remaining light-emitting elements.

Although the disclosure has been described with reference to embodiments, it will be understood by those skilled in the art or those having ordinary knowledge in the art that the disclosure may be variously modified and changed without departing from the scope of the invention as defined in the claims.

## Claims

1. A display device comprising:
an emission area (EMA) and a non-emission area (NEA);
a first alignment electrode (ALE1), a second alignment electrode (ALE2), and a third alignment electrode (ALE3) sequentially arranged in a first direction (DR1);
a plurality of first light-emitting elements (LD1) disposed between the first alignment electrode and the second alignment electrode and a plurality of second light-emitting elements (LD2) disposed between the second alignment electrode and the third alignment electrode;
a first electrode (EL1) electrically connected to a first end portion of each of the plurality of first light-emitting elements and each of the plurality of second light-emitting elements; and
a second electrode (EL2) electrically connected to a second end portion of each of the plurality of first light-emitting elements and each of the plurality of second light-emitting elements, wherein
the emission area (EMA) includes a first area (A1), a second area (A2), and a third area (A3) divided in a second direction (DR2) intersecting the first direction,
the first area is an upper area of the emission area, the second area is a lower area of the emission area, and the third area is a middle area of the emission area in a plan view, and
the first electrode (EL1) is positioned in the first area and the second area and is electrically disconnected in the third area.

2. The display device of claim 1, wherein
the second electrode (EL2) is positioned in the first area, the second area, and the third area, and
the first electrode (EL1) is not positioned in the third area.

3. The display device of claim 2, wherein
a combination of the first electrode and the second electrode comprises a first pixel electrode, a second pixel electrode, a third pixel electrode, and a fourth pixel electrode,
the first electrode comprises the first pixel electrode and the third pixel electrode spaced apart from each other,
the second electrode comprises the second pixel electrode and the fourth pixel electrode spaced apart from each other, and
the first pixel electrode, the second pixel electrode, the fourth pixel electrode, and the third pixel electrode are sequentially disposed in the first direction in the emission area.

4. The display device of claim 3, wherein
the first pixel electrode includes a 1-1 pixel electrode positioned in the first area and a 1-2 pixel electrode positioned in the second area,
the second pixel electrode includes a 2-1 pixel electrode positioned in the first area, a 2-2 pixel electrode positioned in the second area, and a 2-3 pixel electrode positioned in the third area,
the third pixel electrode includes a 3-1 pixel electrode positioned in the first area and a 3-2 pixel electrode positioned in the second area, and
the fourth pixel electrode includes a 4-1 pixel electrode positioned in the first area, a 4-2 pixel electrode positioned in the second area, and a 4-3 pixel electrode positioned in the third area, wherein
the 1-1 pixel electrode and the 1-2 pixel electrode are spaced apart from each other, and
the 3-1 pixel electrode and the 3-2 pixel electrode are spaced apart from each other.

5. The display device of claim 4, wherein
the 2-3 pixel electrode is narrower than the 2-1 pixel electrode and the 2-2 pixel electrode in the first direction, and
the 4-3 pixel electrode is narrower than the 4-1 pixel electrode and the 4-2 pixel electrode in the first direction.

6. The display device of claim 4 or 5, further comprising:
a contact electrode (CNE) which is positioned in the non-emission area and connects the 2-1 pixel electrode and the 3-1 pixel electrode.

7. The display device of any one of claims 4 to 6, further comprising:
a first sub-electrode (SLT1) positioned in the non-emission area and electrically connected to the first pixel electrode; and
a second sub-electrode (SLT2) positioned in the non-emission area and electrically connected to the third pixel electrode, wherein
the first sub-electrode includes a 1-1 sub-electrode electrically connected to the 1-1 pixel electrode, a 1-2 sub-electrode electrically connected to the 1-2 pixel electrode, and a 1-3 sub-electrode electrically connecting the 1-1 sub-electrode and the 1-2 sub-electrode, and
the second sub-electrode includes a 2-1 sub-electrode electrically connected to the 3-1 pixel electrode, a 2-2 sub-electrode electrically connected to the 3-2 pixel electrode, and a 2-3 sub-electrode electrically connecting the 2-1 sub-electrode and the 2-2 sub-electrode.

8. The display device of claim 7, wherein
the 1-3 sub-electrode is narrower than the 1-1 sub-electrode and the 1-2 sub-electrode in the first direction, and
the 2-3 sub-electrode is narrower than the 2-1 sub-electrode and the 2-2 sub-electrode in the first direction.

9. The display device of any one of claims 4 to 8, wherein
the plurality of first light-emitting elements include a (1a)^{th} light-emitting element positioned in the first area and electrically connected to the 1-1 and 2-1 pixel electrodes, and a (1b)^{th} light-emitting element positioned in the second area and electrically connected to the 1-2 and 2-2 pixel electrodes, and
the plurality of second light-emitting elements include a (2a)^{th} light-emitting element positioned in the first area and electrically connected to the 3-1 and 4-1 pixel electrodes, and a (2b)^{th} light-emitting element positioned in the second area and electrically connected to the 3-2 and 4-2 pixel electrodes.

10. The display device of claim 9, wherein
each of the (1a)^{th}, (1b)^{th}, (2a)^{th}, and (2b)^{th} light-emitting elements includes a first semiconductor layer positioned at the first end portion, a second semiconductor layer positioned at the second end portion, and an active layer positioned between the first semiconductor layer and the first semiconductor layer, and
the second semiconductor layer is an n-type semiconductor layer, and the first semiconductor layer is a p-type semiconductor layer.

11. The display device of any one of the preceding claims, further comprising:
a color conversion layer disposed on the plurality of first light-emitting elements and on the plurality of second light-emitting elements; and
a color filter layer disposed on the color conversion layer.

12. The display device of claim 3, wherein
the second pixel electrode is electrically disconnected in the third area, and
the fourth pixel electrode is positioned in the third area and includes a third portion electrically connecting the first portion and the second portion.

13. The display device of claim 12, further comprising:
a dummy pattern positioned between the first portion of the second pixel electrode and the second portion of the second pixel electrode in the third area and spaced apart from the first and second portions.

14. The display device of claim 3, wherein
the fourth pixel electrode is electrically disconnected in the third area,
the second pixel electrode is positioned in the third area and includes a third portion electrically connecting the first portion and the second portion.

15. A method of repairing a display device according to any one of the preceding claims, in which at least one of the plurality of first light-emitting elements or second light-emitting elements is a defective light emitting element and at least one is a non-defective light emitting element, the method comprising:
separating one of the first electrode and the second electrode electrically connected to the at least one non-defective light-emitting element from one of the first and second electrodes electrically connected to the defective light-emitting element,
optionally wherein the one of the first and second electrodes electrically connected to the at least one normal light-emitting element is positioned in the first direction from and in a same column as the one of the first and second electrodes electrically connected to the defective light-emitting element.
